# FASCICULE DE BREVET EUROPEEN

(11) **EP 4 526 917 B1**
(45) Date de publication et mention de la délivrance du brevet: **08.04.2026**
(21) Numéro de dépôt: 23726990.7
(22) Date de dépôt: 15.05.2023
(51) Int. Cl.: H01J 37/32, H05H 1/46, C23C 16/455, C23C 16/52, C23C 16/509, C23C 16/458

(54) **PROCÉDÉ DE DÉPÔT DE COUCHES ATOMIQUES ASSISTÉ PAR PLASMA À COUPLAGE CAPACITIF**
VERFAHREN ZUR KAPAZITIV GEKOPPELTEN PLASMAABSCHEIDUNG VON ATOMSCHICHTEN
METHOD FOR CAPACITIVELY COUPLED PLASMA DEPOSITION OF ATOMIC LAYERS

(30) Priorité: 17.05.2022 FR 2204649
(43) Date de publication de la demande: 26.03.2025
(73) Titulaire: Université Grenoble Alpes, 38400 Saint-Martin-d'Hères (FR); Centre National de la Recherche Scientifique, 75016 Paris (FR)
(72) Inventeur: BONVALOT, Marceline, 38330 Saint-Ismier (FR); CHEVOLLEAU, Thierry, 38120 Saint-Égrève (FR); JAFFAL, Moustapha, 38000 Grenoble (FR)
(74) Mandataire: Hautier IP
(86) Numéro de dépôt international: PCT/EP2023/062989
(87) Numéro de publication internationale: WO 2023/222611

(56) Documents cités:
- JP-A- 2011 124 336
- US-A- 5 540 824
- US-A1- 2009 149 028
- US-A1- 2009 236 214
- US-A1- 2021 313 145
- US-B1- 6 589 437
- US-B2- 11 087 959

## Description

### DOMAINE TECHNIQUE DE L'INVENTION

La présente invention concerne le domaine des procédés de dépôt de couches atomiques assisté par plasma. Elle trouve pour application particulièrement avantageuse le domaine du dépôt de couche mince, et plus particulièrement de couche mince d'épaisseur contrôlée, par exemple pour la fabrication de dispositif microélectronique.

### ETAT DE LA TECHNIQUE

Les procédés de dépôt par couches atomiques (communément désignés par dépôt ALD, de l'anglais Atomic Layer Deposition) sont couramment utilisés pour déposer des couches minces, par exemple à des épaisseurs inférieures ou égales à 100 nm, sur des substrats 2D ou 3D. De façon générale, le dépôt ALD est un procédé cyclique comprenant deux étapes principales :
- une injection d'un précurseur, typiquement un précurseur métallique,
- une injection d'un autre précurseur, typiquement un réactif tel qu'un réactif à base d'oxygène ou d'azote.

Ces étapes sont auto-limitantes, ce qui permet de déposer des couches conformes et uniformes sur le substrat. L'énergie nécessaire à la réaction des précurseurs peut typiquement être apportée par la température (on parle alors d'ALD thermique). Cette énergie peut être apportée en utilisant une assistance par un plasma (communément désigné PEALD, de l'anglais Plasma Enhanced ALD) pour améliorer la réactivité de surface. Cela permet notamment de diminuer la température de travail, typiquement à des températures inférieures ou égales à 250°C.

Les procédés ALD assistés par plasma ont été utilisés pour déposer de nombreux matériaux qui restent difficiles à déposer par ALD thermique. Pour certains dépôts, les procédés ALD thermiques peuvent être trop peu réactifs et/ou nécessiter des précurseurs organiques complexes.

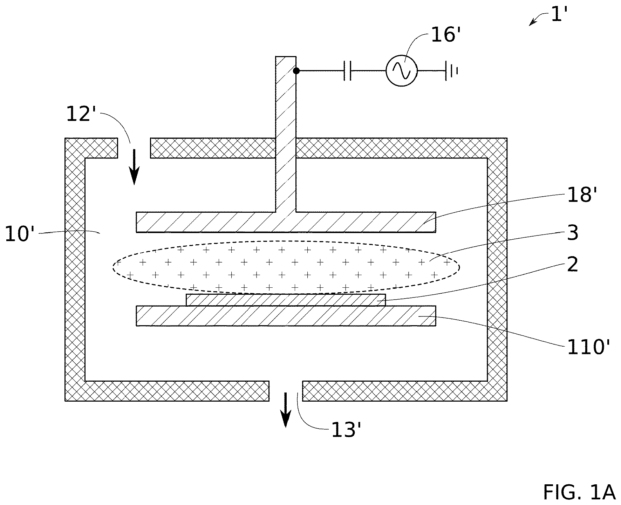

De façon classique, les procédés PEALD mettent en œuvre des plasmas à couplage capacitif ou à couplage inductif (respectivement communément désignées CCP, de l'anglais Capacitively Coupled Plasma, et ICP, de l'anglais Inductively Coupled Plasma). Pour cela, ces procédés sont réalisés dans des réacteurs comprenant généralement une chambre 10' de réaction, une arrivée de précurseur gazeux 12' configurée pour amener des précurseurs gazeux dans la chambre 10', et un module de pompage 13' de la chambre 10'. Dans un réacteur 1' CCP conventionnel, par exemple illustré en figure 1A, le plasma est typiquement généré 3 typiquement à des pressions de l'ordre de quelques Torr entre deux électrodes 110', 18' avec un dispositif de puissance radiofréquence (RF) 16'. Les électrodes 110', 18' sont disposées parallèlement l'une en face de l'autre et le substrat est déposé entre elles, une électrode 110' étant le plateau relié à la masse 110' portant le substrat 2. Dans les procédés classiques de CCP, le bombardement ionique sur le plateau est toutefois important. Des grilles peuvent être ajoutées dans l'espace inter-électrodes pour limiter ce bombardement ionique.

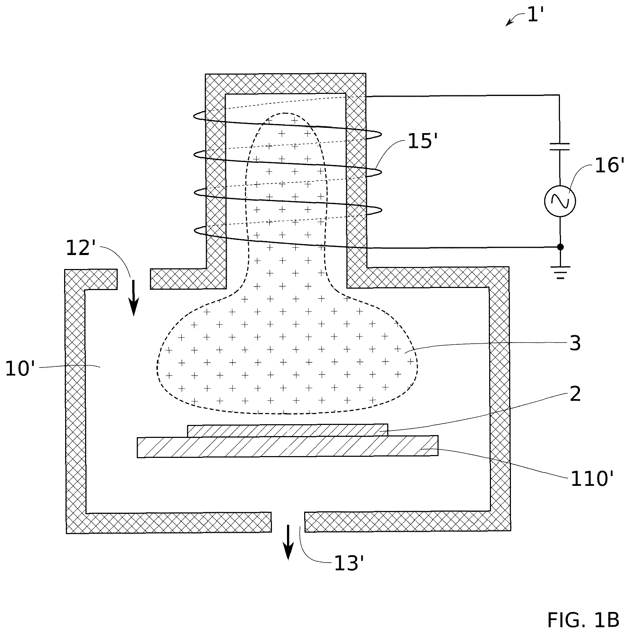

Dans un réacteur 1' ICP, par exemple illustré en figure 1B, le plasma est généré 3, typiquement à des pressions de l'ordre de 100 mTorr et de façon déportée, par une source 15' par induction avec un dispositif de puissance RF 16', puis est amené dans la chambre de réaction 10' jusqu'au substrat 2 par diffusion. Le bombardement ionique est ainsi limité.

Le document US 11 087 959 B2 décrit un procédé de réalisation de dépôts PEALD et PECVD, par une source ICP conventionnelle.

En effet, le bombardement ionique peut générer des défauts ponctuels ou étendus, tels que des implantations, déplacements d'atomes, stress en compression dans la couche en croissance, voire sa pulvérisation.

Cependant le bombardement ionique peut être bénéfique pour moduler la réactivité de surface et améliorer les propriétés du dépôt telles que la densité, la morphologie, la contrainte, la conformité notamment sur un substrat 3D, à condition que l'énergie de ce bombardement et sa densité ionique soient maîtrisées.

À cette fin, certains procédés récemment développés utilisent des plasmas ICP auxquels une polarisation RF supplémentaire a été ajoutée au niveau du porte-substrat, pour permettre l'extraction des ions du plasma déporté avec une énergie incidente contrôlée au moment où ils arrivent au voisinage du substrat.

En pratique, les matériaux élaborés dans ces réacteurs sont surtout des oxydes ou des nitrures, dont les propriétés physico-chimiques peuvent être éventuellement modulées par une polarisation supplémentaire permettant d'extraire les ions du plasma pour qu'ils assistent les mécanismes de croissance. L'obtention d'autres matériaux reste limitée.

Un bombardement ionique mal maîtrisé peut en outre affecter les propriétés visées de la couche déposée, et le substrat peut être endommagé par le bombardement ionique.

Un objet de la présente invention est donc de proposer une solution améliorée de dépôt assisté par plasma. Un objectif non limitatif de l'invention peut être de proposer un procédé amélioré de dépôt par couche atomique assisté par plasma, et notamment en termes de nature de couche déposée et/ou de sélectivité du dépôt.

Les autres objets, caractéristiques et avantages de la présente invention apparaîtront à l'examen de la description suivante et des dessins d'accompagnement. Il est entendu que d'autres avantages peuvent être incorporés.

### RESUME DE L'INVENTION

Pour atteindre cet objectif, selon un aspect on prévoit un procédé de dépôt de couches atomiques assisté par plasma comprenant :
- une fourniture d'un substrat présentant une surface exposée dans un réacteur plasma, le réacteur plasma comprenant une chambre de réaction délimitée par des parois et un plateau électriquement conducteur. Le plateau électriquement conducteur présente une face supérieure sur laquelle est disposé le substrat. Une paroi latérale de la chambre de réaction est au moins en partie non parallèle à la face supérieure du plateau et électriquement conductrice.
- une pluralité de cycles de dépôt de couches atomiques sur la surface exposée du substrat, chaque cycle comprenant :
   ∘ une injection dans la chambre de réaction d'un précurseur à base d'une première espèce,
   ∘ un traitement plasma de la surface exposée du substrat par un plasma généré par couplage capacitif entre le plateau et la paroi latérale, par application d'une puissance radiofréquence au plateau.

Grâce à la configuration non parallèle des deux électrodes, le couplage capacitif entre le plateau et les parois de la chambre permet de créer un plasma localisé au voisinage du substrat, à une énergie et une densité des ions faibles et finement ajustables, notamment par rapport à un réacteur CCP classique. Ces paramètres peuvent être ajustés selon les conditions de puissance RF et de pression. Cela limite ainsi grandement les dommages au substrat occasionnés par le bombardement ionique. Ce flux ionique plus faible est en outre plus finement contrôlable par rapport à un réacteur ICP avec polarisation du substrat, ce qui permet d'aboutir à un meilleur compromis entre les dommages induits au substrat et l'efficacité du bombardement ionique. Cela limite ainsi grandement les dommages au substrat par rapport au réacteur CCP et au réacteur ICP avec polarisation du substrat.

En outre, cela permet d'accéder à des paramètres de plasma permettant des dépôts de chimie et de microstructure variées, comme cela apparaîtra à la lecture de la description.

Selon un deuxième aspect, on prévoit un réacteur de dépôt assisté par plasma comprenant :
- une chambre de réaction délimitée par des parois et comprenant un plateau électriquement conducteur présentant une face supérieure destinée à recevoir un substrat,
- une arrivée de précurseur gazeux configurée pour amener des précurseurs gazeux dans la chambre de réaction,
- un module de pompage de la chambre de réaction,
- une source de puissance configurée pour appliquer une puissance radiofréquence au plateau.

Une paroi latérale de la chambre de réaction est au moins en partie non parallèle à la face supérieure du plateau et est électriquement conductrice. La face supérieure du plateau et la paroi latérale sont séparées d'une distance configurée de façon à générer un plasma par couplage capacitif entre le plateau et la paroi latérale.

La puissance radiofréquence appliquée au plateau et la distance entre le plateau et la paroi latérale permettent de générer le plasma par couplage capacitif entre ces deux éléments. Le plasma est ainsi généré de façon localisée au voisinage du substrat, grâce à la configuration non parallèle des deux électrodes, ce qui présente les avantages décrits ci-dessus. Enfin, ce réacteur permet des dépôts de couches de chimie et microstructures plus variées qu'un réacteur ICP conventionnel avec ou sans polarisation du substrat.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A représente une vue en coupe d'un réacteur CCP selon un exemple de l'état de la technique.
La figure 1B représente une vue en coupe d'un réacteur ICP selon un exemple de l'état de la technique.
La figure 2 représente un schéma du procédé de dépôt, selon un exemple de réalisation.
Les figures 3A à 3E représentent un schéma d'un cycle de dépôt d'une couche métallique, selon plusieurs exemples de réalisation.
Les figures 4A à 4C représentent un schéma d'un cycle de dépôt d'une couche d'oxyde, de nitrure et/ou de sulfure, selon plusieurs exemples de réalisation.
La figure 5 représente une vue en coupe du réacteur plasma selon un exemple de réalisation, dans lequel la paroi latérale est de géométrie conique.
La figure 6 représente une vue en coupe du réacteur plasma selon un autre exemple de réalisation, dans lequel la paroi latérale est de géométrie hémisphérique.
La figure 7 représente une vue en coupe du réacteur plasma selon un autre exemple de réalisation, couplé à une source ICP.
La figure 8 représente une vue en coupe du réacteur plasma illustré en figure 5, équipé d'un ellipsomètre.
Les figures 9A à 9D et 10A à 10C représentent des graphiques flux d'ions générés par le plasma selon les paramètres du plasma, respectivement à puissance et à pression constante.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives du substrat, des couches déposées et du réacteur ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles du procédé et du réacteur plasma qui peuvent éventuellement être utilisées en association ou alternativement.

Selon un exemple, le plateau est polarisé à la masse.

Selon un exemple, la pluralité de cycles de dépôt comprend en outre une injection dans la chambre de réaction d'un précurseur à base d'une deuxième espèce.

Selon un exemple, le traitement plasma est effectué simultanément à au moins une injection dans la chambre de réaction d'un précurseur ou suite à au moins une injection dans la chambre de réaction d'un précurseur. Cela permet de moduler les réactions de surface lors d'une injection ou entre deux injections. Cette modulation est notamment rendue possible grâce au plasma de faible densité généré.

Selon un exemple, la puissance de la polarisation radiofréquence peut être inférieure ou égale à 80 W. La pression dans la chambre de réaction peut être inférieure ou égale à 80 mTorr. La durée du traitement plasma au cours d'un cycle de dépôt peut être inférieure ou égale à 1 minute. Lors du développement de l'invention, il a été mis en évidence que ces paramètres permettent d'activer et/ou de modifier la réactivité de surface entre les injections de précurseur. Ces conditions plasma peuvent modifier avantageusement les propriétés du matériau déposé.

Selon un exemple, la puissance de la polarisation radiofréquence peut être supérieure ou égale à 50 W. La pression dans la chambre de réaction peut être inférieure ou égale à 20 mTorr. La durée du traitement plasma au cours d'un cycle de dépôt est supérieure ou égale à 1 minute. Lors du développement de l'invention, il a été mis en évidence que ces paramètres permettent de retirer, voire de pulvériser le précurseur chimisorbé à la surface. Ces conditions plasma peuvent être utiles pour des dépôts sélectifs sur des substrats 3D.

Selon un exemple, lorsque le plasma est généré, le traitement plasma comprend l'injection dans la chambre de réaction d'un gaz rare, aussi désigné gaz inerte, de préférence de l'argon, éventuellement en mélange avec H₂. Un plasma dit « inerte » à base d'argon est faible en énergie par rapport à d'autres espèces. De façon synergique avec le plasma capacitif de faible densité généré, cela permet de moduler les réactions de surface en minimisant le risque d'abimer la surface exposée du substrat.

Selon un exemple, le traitement plasma étant effectué simultanément à et/ou après l'injection du précurseur à base de la première espèce, la première espèce est à base d'un métal. Le traitement plasma permet ainsi l'élimination du ligand du précurseur métallique et donc l'adsorption métal sur métal, par création de liaisons pendantes lorsque le plasma est généré à partir d'un gaz inerte, par exemple de l'argon, ou réducteur, par exemple H₂.

Selon un exemple, le traitement plasma étant effectué entre l'injection du précurseur à base de la première espèce et l'injection du précurseur à base de la deuxième espèce et/ou simultanément à au moins l'une desdites injections, la première espèce est à base d'un métal et la deuxième espèce est à base d'un métal.

Selon un exemple, lorsque le plasma est généré, le traitement plasma est exempt d'injection de dihydrogène. Lors du développement de l'invention, il a en effet été mis en évidence que le procédé ne nécessite pas de réduction de la couche en croissance par du dihydrogène.

De préférence, lorsque la première espèce est un métal, la puissance de la polarisation radiofréquence peut être inférieure ou égale à 80 W. La pression dans la chambre de réaction peut être inférieure ou égale à 80 mTorr. La durée du traitement plasma au cours d'un cycle de dépôt peut être inférieure ou égale à 1 minute. La dose apportée par le bombardement ionique permet d'éliminer et/ou de modifier les ligands du précurseur pour favoriser le dépôt d'une couche métallique. La dose déposée est limitée, ce qui améliore encore l'élimination du ligand sans risquer d'enlever le métal déposé.

Selon un exemple, le métal présente une électronégativité comprise entre 1,1 et 2,4.

De préférence, le métal est choisi parmi le groupe constitué de titane, tantale, aluminium, argent, zinc, ruthénium, platine, cuivre.

Selon un exemple, la première espèce comprend le métal et des ligands alkyls, amines, oxygénés (par exemple des carbonyles) ou halogénés.

Selon un exemple, le traitement plasma étant effectué simultanément à l'injection du précurseur à base de la première espèce, le traitement plasma et l'injection du précurseur sont chacun faits par impulsions simultanées ou séquentielles entre le traitement plasma et l'injection du précurseur. Une réduction in situ du précurseur est ainsi faite soit dans la phase gazeuse, soit au niveau des adsorbats. Le procédé obtenu peut être qualifié de mode CVD pulsé, et autolimitant avec le déphasage entre l'impulsion du précurseur et le traitement plasma. De préférence, selon cet exemple, la première espèce comprend le métal et des ligands alkyls.

Selon un exemple, le traitement plasma étant effectué après l'injection du précurseur à base de la première espèce, par exemple avant et/ou simultanément à l'injection du précurseur à base de la deuxième espèce, et/ou après l'injection du précurseur à base de la deuxième espèce, la première espèce est à base d'un métal et la deuxième espèce comprend l'un au moins parmi les éléments oxygène, azote et soufre. Selon la dose de précurseur métallique déposée, la quantité et la réactivité du précurseur à base d'oxygène, azote ou soufre peut être limitée pour moduler la réactivité de surface avant l'injection du précurseur métallique du cycle suivant.

Selon un exemple, le traitement plasma étant effectué simultanément à l'injection du précurseur à base de la deuxième espèce, la deuxième espèce est choisie parmi le groupe constitué de O₂, N₂ (éventuellement en mélange avec H₂), NH₃, H2_{S}.

Selon un exemple, le traitement plasma étant effectué après l'injection du précurseur à base de la deuxième espèce, la deuxième espèce est choisie parmi le groupe constitué de H₂O, O₂, NH₃.

Selon un exemple, lorsque la première espèce est à base d'un métal et la deuxième espèce comprend l'un au moins parmi les éléments oxygène, azote et soufre, la puissance de la polarisation radiofréquence peut être inférieure ou égale à 80 W. La pression dans la chambre de réaction peut être inférieure ou égale à 80 mTorr. La durée du traitement plasma au cours d'un cycle de dépôt est inférieure ou égale à 1 minute. Ainsi, la réactivité de surface entre le précurseur à base de la première espèce, le précurseur à base de la deuxième espèce (réactant thermique ou plasma) et/ou les radicaux du plasma d'oxydation, de nitruration ou de sulfuration peut être activée et/ou modifiée. Ces conditions plasma peuvent modifier avantageusement les propriétés du matériau déposé

Selon un exemple alternatif, lorsque la première espèce est à base d'un métal et la deuxième espèce comprend l'un au moins parmi les éléments oxygène, azote et soufre, la puissance de la polarisation radiofréquence peut être supérieure ou égale à 50 W. La pression dans la chambre de réaction peut être inférieure ou égale à 20 mTorr. La durée du traitement plasma au cours d'un cycle de dépôt est supérieure ou égale à 1 minute. Le précurseur chimisorbé à la surface peut ainsi être retiré, voire pulvérisé. Ces conditions plasma peuvent être utiles pour des dépôts sélectifs sur des substrats 3D.

Selon un exemple, le plateau étant configuré pour être ajusté en hauteur dans la chambre de réaction, le procédé comprend un ajustement de la hauteur du plateau préalablement au traitement plasma, de préférence préalablement au cycle de dépôt. Ainsi, la distance d peut être ajustée par la hauteur du plateau, par exemple pour différentes valeurs de pression ou de tension de polarisation, selon les besoins. Le réacteur gagne donc en versatilité. Lorsque le réacteur comprend en outre une source plasma à couplage inductif déportée de la chambre de réaction, cela permet en outre d'ajuster la distance d entre le plateau et la paroi latérale, ce qui est particulièrement avantageux en synergie avec une source ICP additionnelle. Il est ainsi possible de coupler ou de découpler les plasmas CCP et ICP selon les besoins.

Selon un exemple, le traitement plasma est configuré de sorte que le plasma présente les caractéristiques de flux ionique suivantes :
- densité de puissance : 0,05 à 0,5 W/cm²,
- flux ionique : 10¹² à 10¹⁴ ions/(cm².s),
- énergie des ions : 0 à 300 eV.

Pour cela, la pression dans la chambre, la fréquence de la polarisation radiofréquence et la puissance de la polarisation fréquence peuvent notamment être adaptées, comme décrit plus en détail ultérieurement.

Selon un exemple, le réacteur est un réacteur de dépôt par couche atomique assisté par plasma.

Selon un exemple, le réacteur est configuré pour générer un plasma présentant une densité d'ions sensiblement inférieure ou égale à 10¹⁴ ions.cm⁻².s⁻¹. Ce plasma de faible densité, localisé au voisinage du substrat permet de tirer plus finement bénéfice du bombardement ionique.

Selon un exemple, la distance, et par exemple la distance minimale, entre la face supérieure du plateau et la paroi latérale est comprise entre 5 cm et 15 cm, de préférence entre 5 cm et 12 cm. Cette gamme de distance permettant l'auto-entretien de la décharge est dictée par la loi de Paschen, fonction de la pression P dans le réacteur, et de la tension moyenne minimale Uₘᵢₙ de la puissance RF : Uₘᵢₙ = P.d. Cela permet d'obtenir une densité d'ions ≤ 10¹⁴ cm⁻².s⁻¹ pour un plasma à très faible densité, facilitant encore l'ajustement des caractéristiques du plasma. Cela permet en outre d'obtenir le plasma à faible densité sans trop diminuer la pression dans la chambre de réaction, pour des pressions de l'ordre du mTorr à quelques centaines de mTorr, par exemple 200 mTorr.

Selon un exemple, la distance d est proportionnelle, et de préférence égale, au rapport de U/P, P étant la pression dans le réacteur, et U la tension moyenne de la polarisation radiofréquence appliquée au plateau, U étant supérieur ou égal à une valeur Uₘᵢₙ de tension moyenne minimale d'auto-polarisation radiofréquence.

Selon un exemple, la paroi latérale est au moins en partie disposée de façon perpendiculaire par rapport au plan d'extension principale de la face supérieure du plateau. La paroi latérale est ainsi sensiblement verticale.

Selon un exemple, la paroi latérale est au moins en partie disposée de façon oblique par rapport au plan d'extension principale de la face supérieure du plateau. Les effets de bords sont ainsi évités et les lignes de champ sur le substrat sont atténuées par rapport à une paroi verticale.

Selon un exemple, la paroi latérale est disposée par rapport au plan d'extension principale de la face supérieure du plateau, de façon à former un angle compris entre 15° et 85°, de préférence entre 30° et 80°. Selon un exemple, et notamment lorsque la paroi latérale est en forme de dôme, la tangente de la paroi latérale définit un angle compris entre 15° et 85°, de préférence entre 30° et 80°. La tangente de la paroi latérale peut être la tangente à un point de la paroi latérale située dans le plan d'extension principale de la face supérieure du plateau.

Selon un exemple, la paroi latérale électriquement conductrice est au moins en partie disposée au-dessus du plateau, en projection selon un plan vertical, ou sensiblement perpendiculaire à la face supérieure du plateau.

Selon un exemple, la paroi latérale présente une symétrie de révolution autour d'une direction perpendiculaire et sensiblement centrée par rapport à la face supérieure du plateau. Cette symétrie permet un amorçage du plasma sur toute la surface de la face supérieure. Le plasma est donc plus homogène.

Selon un exemple, la paroi latérale ne présente pas une symétrie de révolution autour d'une direction perpendiculaire et sensiblement centrée par rapport à la face supérieure du plateau. On peut par exemple prévoir que la paroi latérale conductrice n'entoure qu'en partie le plateau, en projection dans un plan parallèle au plan d'extension principale de la face supérieure du plateau.

Selon un exemple, la paroi latérale forme au moins en partie un cône au-dessus du plateau, de préférence la paroi latérale présente une géométrie conique d'axe de révolution sensiblement centré par rapport au plateau.

Selon un exemple, la paroi latérale forme au moins en partie un dôme au-dessus du plateau, de préférence la paroi latérale présente au moins en partie une géométrie hémisphérique, de préférence sensiblement centrée par rapport au plateau.

Selon un exemple, le réacteur est configuré de sorte que le plasma est généré uniquement dans la chambre de réaction par la puissance appliquée sur le porte-substrat. Ainsi, le réacteur est d'une configuration simplifiée, et donc moins coûteuse que celle d'un réacteur PEALD ICP conventionnel.

Selon un exemple, le réacteur est configuré de sorte que le plasma est généré entre deux électrodes uniquement et le réacteur est configuré de sorte que le plateau constitue l'une des deux électrodes. À titre de comparaison, dans un réacteur ICP, le plasma ICP est généré uniquement par une spire alimentée par une puissance RF.

Selon un exemple, le réacteur est exempt d'une source additionnelle de type ICP plasma.

Selon un exemple, le plateau n'est pas configuré pour être ajusté en hauteur dans la chambre de réaction. La configuration du réacteur est ainsi encore simplifiée.

Selon un exemple, le réacteur comprend en outre une source plasma à couplage inductif déportée de la chambre de réaction. Le réacteur est ainsi un réacteur multimode permettant un dépôt assisté par plasma ICP et/ou par le plasma généré entre le plateau et la paroi latérale, selon les besoins. Le réacteur permet ainsi de réaliser différents procédés de dépôt selon les besoins.

Lorsque le réacteur comprend en outre une source plasma à couplage inductif déportée de la chambre de réaction, le réacteur peut comprendre deux sources plasma indépendantes et pouvant être utilisées au choix : la source de puissance pour le couplage CCP et la source plasma à couplage inductif pour le couplage ICP. Les puissances de polarisation appliquées par ces deux sources peuvent être réglées indépendamment.

Selon un exemple, le plateau n'est pas configuré pour être ajusté en hauteur dans la chambre de réaction.

Selon un exemple, le plateau est configuré pour être ajusté en hauteur dans la chambre de réaction. Ainsi, la distance d peut être ajustée par la hauteur du plateau, par exemple pour différentes valeurs de pression ou de tension de polarisation, selon les besoins. Le réacteur gagne donc en versatilité. Lorsque le réacteur comprend en outre une source plasma à couplage inductif déportée de la chambre de réaction, la distance d entre le plateau et la paroi latérale peut être ajustée, ce qui est particulièrement avantageux pour moduler les propriétés du plasma au voisinage du substrat. Il est ainsi possible de découpler ou de coupler les deux plasmas de type CCP et ICP selon les besoins.

Selon un exemple, l'arrivée de précurseurs gazeux et le module de pompage sont configurés pour maintenir, au moins lorsque le plasma est généré, une pression sensiblement comprise entre 5 et 200 mTorr, de préférence comprise entre 5 mTorr et 100 mTorr dans la chambre de réaction, de préférence comprise entre 5 mTorr et 80 mTorr dans la chambre de réaction, au moins lorsque le plasma est généré. Ces pressions correspondent à un vide secondaire poussé.

Selon un exemple l'arrivée de précurseurs gazeux et le module de pompage sont configurés pour maintenir une pression sensiblement inférieure ou égale à 200 mTorr, de préférence à 100 mTorr dans la chambre de réaction, au moins lorsque le plasma est généré.

Selon un exemple l'arrivée de précurseurs gazeux et le module de pompage sont configurés pour maintenir une pression sensiblement supérieure ou égale à 10 mTorr dans la chambre de réaction, au moins lorsque le plasma est généré, de préférence supérieure ou égale à 15 mTorr.

Selon un exemple, la source de puissance est configurée pour appliquer la puissance radiofréquence avec une fréquence comprise entre 2 et 100 MHz, lorsque le plasma est généré par couplage capacitif entre le plateau et la paroi latérale, ou de façon équivalente pour générer un plasma par couplage capacitif entre le plateau et la paroi latérale.

Selon un exemple, la source de puissance (pour le couplage CCP) est configurée pour appliquer la puissance radiofréquence avec une puissance inférieure ou égale à 100 W, lorsque le plasma est généré par couplage capacitif entre le plateau et la paroi latérale. Selon un exemple, une puissance radiofréquence non nulle inférieure ou égale à 100 W est appliquée au plateau.

La source plasma à couplage inductif déportée de la chambre de réaction peut être configurée pour appliquer une puissance radiofréquence avec une puissance non nulle en valeur absolue comprise entre 0 et 300 W.

Selon un exemple, le procédé comprend en outre un ajustement d'au moins deux paramètres du plasma, ces paramètres comprenant la distance d, la pression P dans le réacteur, la tension U moyenne de la polarisation radiofréquence appliquée au plateau, de sorte que :
- d est proportionnelle, et de préférence égale, au rapport de U/P,
- U est supérieur ou égal à une valeur Umin de tension moyenne minimale d'auto-polarisation. De préférence, cet ajustement est effectué avant le traitement plasma de la surface exposée. Ainsi, les paramètres peuvent être ajustés sans impacter le dépôt sur le substrat.

Selon un exemple, le plateau du réacteur étant configuré pour être ajusté en hauteur dans la chambre de réaction, le procédé comprend un ajustement de la distance d par un déplacement en hauteur du plateau, de façon à atteindre une distance d permettant la génération du plasma. On peut ainsi se placer à une distance ne permettant pas la génération du plasma, et déplacer le plateau jusqu'à observer un plasma. De préférence, cet ajustement est effectué avant le traitement plasma de la surface exposée.

Selon un exemple, lors du traitement plasma, la pression dans la chambre de réaction est sensiblement comprise entre 5 et 200 mTorr, de préférence comprise entre 5 mTorr et 100 mTorr. Par exemple, l'apport de précurseurs peut être configuré pour atteindre cette pression préalablement à la génération du plasma. L'arrivée de précurseur gazeux et le module de pompage peuvent être configurés pour maintenir cette pression.

Selon un exemple, lors de l'ajustement des paramètres plasma est réalisé, le procédé comprend en outre une application de la puissance radiofréquence. Les paramètres ci-dessus permettent d'obtenir les caractéristiques de flux ionique suivantes du plasma au niveau du plateau :
- densité de puissance : 0,05 à 0,5 W/cm²,
- flux ionique : 10¹² à 10¹⁴ ions/(cm².s),
- énergie des ions : 0 à 300 eV.

Selon un exemple, la source de puissance comprend un atténuateur configuré pour limiter la puissance de la polarisation radiofréquence du plasma généré par couplage capacitif.

Dans la suite de la description, le terme « sur » ne signifie pas nécessairement « directement sur ». Ainsi, lorsque l'on indique qu'une pièce ou qu'un organe A est en appui « sur » une pièce ou un organe B, cela ne signifie pas que les pièces ou organes A et B soient nécessairement en contact direct avec l'autre. Ces pièces ou organes A et B peuvent être soit en contact direct soit être en appui l'une sur l'autre par l'intermédiaire d'une ou plusieurs autres pièces. Il en est de même pour d'autres expressions telles que par exemple l'expression « A agit sur B » qui peut signifier « A agit directement sur B » ou « A agit sur B par l'intermédiaire d'une ou plusieurs autres pièces ».

Dans la présente demande de brevet, le terme mobile correspond à un mouvement de rotation ou à un mouvement de translation ou encore à une combinaison de mouvements, par exemple la combinaison d'une rotation et d'une translation.

Dans la description détaillée qui suit, il pourra être fait usage de termes tels que « horizontal », « vertical », « longitudinal », « transversal », « supérieur », « inférieur », « haut », « bas », « avant », « arrière », « intérieur », « extérieur ». Ces termes doivent être interprétés de façon relative en relation avec la position normale d'utilisation du réacteur. Par exemple, les notions « horizontal » et « longitudinal » correspondent à la direction d'extension principale de la face supérieure du plateau.

On utilisera également un repère dont la direction longitudinale ou droite/gauche correspond à l'axe x, la direction transversale ou arrière/avant correspond à l'axe y et la direction verticale ou bas/haut correspond à l'axe z.

Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS, LED...).

Il peut s'agir d'un dispositif destiné à assurer une fonction électronique, optique, mécanique etc. Il peut aussi s'agir d'un produit intermédiaire uniquement destiné à la réalisation d'un autre dispositif microélectronique.

Par ailleurs, un plasma à base d'une espèce peut être basé sur ou de façon équivalente formé d'une chimie comprenant uniquement cette espèce et éventuellement une ou plusieurs autres espèces, par exemple un gaz rare tels que l'argon ou l'hélium.

Le terme « étape » s'entend de la réalisation d'une partie du procédé, et peut désigner un ensemble de sous-étapes. Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Dans la présente demande de brevet lorsque l'on exprime un mélange gazeux avec des pourcentages, ces pourcentages correspondent à des fractions du débit total des gaz injectés dans le réacteur. Ainsi, si un mélange gazeux, par exemple destiné à former un plasma, comprend x % du gaz A, cela signifie que le débit d'injection du gaz A correspond à x % du débit total des gaz injectés dans le réacteur pour former le plasma.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Le procédé 4 de dépôt de couches atomiques assisté par plasma et le réacteur 1 sont maintenant décrits plus en détail selon des exemples de réalisation.

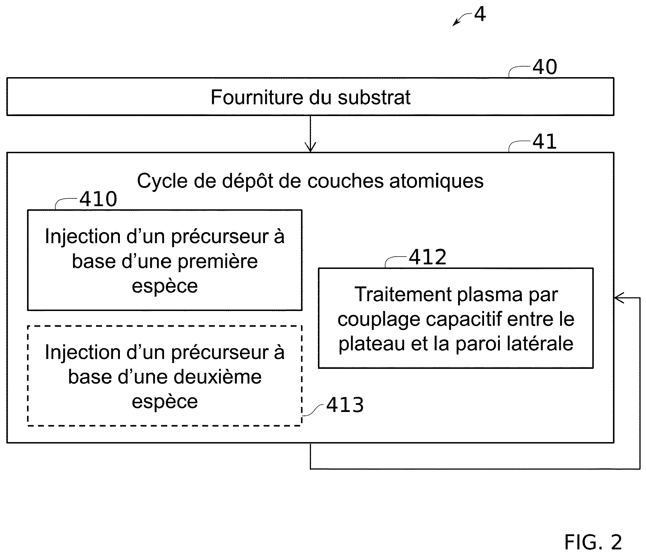

La figure 2 illustre le procédé 1 selon un exemple de réalisation. Les étapes optionnelles sont indiquées en pointillés. Le procédé 4 comprend tout d'abord une fourniture 40 d'un substrat 2 présentant une surface exposée 20. Ce substrat 2 est fourni dans un réacteur plasma 1 comprenant une chambre de réaction 10. Le réacteur 1 est configuré de façon à générer un plasma par couplage capacitif entre un plateau 110 et une paroi latérale 100 de la chambre de réaction 10 du réacteur 1. Des exemples de réacteur plasma 1 seront décrits plus en détail ultérieurement.

Suite à la fourniture 40 du substrat 2, le procédé 4 comprend une pluralité de cycles 41 de dépôt de couches atomiques sur la surface exposée 20 du substrat 2. Un cycle 41 de dépôt comprend une injection dans la chambre de réaction 10 d'un précurseur à base d'une première espèce 410. Le cycle 41 comprend en outre un traitement plasma 412 de la surface exposée 20 du substrat 2 par le plasma généré par couplage capacitif entre le plateau 110 et la paroi latérale 100 de la chambre de réaction 10. Comme nous le verrons dans la suite, tout ordre relatif entre la ou les injections de précurseur et le traitement plasma sont envisageables, y compris un traitement plasma suivi de la ou les injections de précurseur.

Le plasma est généré par application d'une puissance radiofréquence au plateau 110. Le plasma est ainsi généré de façon localisée au voisinage 3 du substrat 2 avec un flux ionique beaucoup plus faible que pour un réacteur CCP conventionnel. Ce réacteur 1 permet de tirer bénéfice du bombardement ionique de faible énergie pour améliorer les propriétés du matériau (densité, pureté, structure cristalline, contrainte interne). De plus, il ouvre de nouvelles voies de développement de procédés concernant les métaux, les oxydes, les nitrures et les sulfures sur des substrats 2D et 3D, ainsi que des procédés de dépôts sélectifs de surface et topographiques.

Comme l'illustre la figure 2, le cycle 41 peut comprendre en outre une injection d'un précurseur à base d'une deuxième espèce 413. Le cycle 41 peut être répété un nombre de fois n de façon à atteindre l'épaisseur de couche voulue. Selon l'ordre relatif entre les injections de précurseur 410, 413 et le traitement plasma 412, ainsi que selon les paramètres du traitement plasma 412, les réactions de surface et donc les propriétés de la couche en croissance peuvent être modifiées. Plusieurs exemples de cycle 41 de dépôt sont décrits ci-dessous à titre non limitatif. Il est entendu que ces caractéristiques peuvent être combinées pour aboutir à d'autres exemples de réalisation, sauf mention explicite du contraire.

Selon exemple, le traitement plasma 412 est effectué simultanément à au moins une injection 410, 413 ou suite à au moins une de ces injections 410, 413 dans la chambre de réaction 10. Par simultanément on entend que le traitement plasma 412 est réalisé au moins en partie en même temps que la ou les injection(s) 410, 413 en question. On peut prévoir un décalage entre le traitement plasma 412 et la ou les injection(s) 410, 413.

Lors du développement de l'invention, plusieurs régimes de traitement plasma ont été mis en évidence, selon le dépôt visé. Selon un premier exemple, la puissance de la polarisation peut être inférieure ou égale à 80 W, la pression à la chambre de réaction 10 peut être inférieure ou égale à 80 mTorr, et la durée du traitement plasma 412 au cours d'un cycle 41 peut être inférieure ou égale à une minute. Ces paramètres permettent d'activer et/ou de modifier la réactivité de surface entre les injections de précurseur, d'un même cycle 41 ou entre des cycles de succédant. Notamment, ces paramètres permettent de jouer sur la réactivité des ligands des précurseurs pour influer sur la couche en croissance. Selon un deuxième exemple, en alternative, la puissance de la polarisation radiofréquence peut être supérieure ou égale à 50 W, la pression à chambre de réaction 10 peut être inférieure ou égale à 20 mTorr, et la durée du traitement plasma 412 au cours d'un cycle 41 peut être supérieure ou égale à une minute. Ces paramètres permettent de retirer le précurseur chimisorbé à la surface. Le matériau déposé peut ainsi croître sur des portions de couches localisées. Ces conditions permettent donc un dépôt sélectif, par exemple sur du substrat 3D.

Chaque injection 410, 413 et/ou chaque traitement plasma 412 peut être suivi d'une phase de purge 414. Cette purge 414 permet d'éliminer les espèces qui ne se sont pas déposées sur la surface exposée 20 du substrat 2, ainsi que d'éliminer les produits de réaction.

Lors de la génération du plasma, le traitement plasma 412 peut comprendre l'injection d'un gaz rare, aussi désigné gaz inerte, tel que de l'hélium ou de l'argon, dans la chambre de réaction 10. Ce gaz peut-être en outre en mélange avec du dihydrogène H₂. Un plasma à base d'argon est en effet faible en énergie par rapport à d'autres espèces. Les réactions de surface peuvent être plus finement modulées encore, en synergie avec le plasma capacitif de faible densité généré, tout en limitant le risque d'abîmer la surface exposée 20.

Le traitement plasma 412 mettant en œuvre un plasma capacitif généré entre le plateau 110 et la paroi latérale 100, et donc un plasma de faible densité, le procédé 4 permet des dépôts de couches de nature variée et notamment de couches dont le dépôt par les procédés conventionnels de dépôt assisté par plasma reste limité.

Par exemple, le procédé 4 permet de déposer une couche métallique sur la surface exposée 20 du substrat 2. Des exemples de dépôt de couches métalliques sont maintenant décrits.

Le cycle 41 peut comprendre l'injection d'un précurseur à base d'un métal 410. Un cycle 41 peut comprendre uniquement une injection d'un précurseur à base d'un premier métal. Le cycle 41 peut en alternative comprendre une injection d'un deuxième précurseur à base d'un métal 413a et notamment d'un précurseur à base d'un métal distinct du premier métal. Lorsque plusieurs précurseurs à base de différents métaux sont utilisés, le procédé permet le dépôt d'une couche d'alliage métallique.

Pour déposer une couche métallique, les précurseurs injectés lors d'un cycle sont de préférence tous à base d'un métal. On distingue un précurseur d'un gaz injecté dans la chambre 10 lors du traitement plasma 412, destiné à former l'atmosphère réactive du plasma tel qu'un gaz neutre ou du d'hydrogène H₂, ce gaz pouvant ne pas comprendre de métal selon cet exemple.

Pour déposer une couche métallique, le traitement plasma 412 peut être effectué simultanément à et/ou après l'injection du premier précurseur à base d'un métal 410. En alternative ou en complément, le traitement plasma 412 peut être effectué simultanément à et/ou après l'injection du deuxième précurseur 413a. Ainsi le traitement plasma 412 permet d'éliminer le ligand du précurseur métallique. Cela favorise l'absorption métal sur métal lors de la croissance de la couche par création de liaisons pendantes.

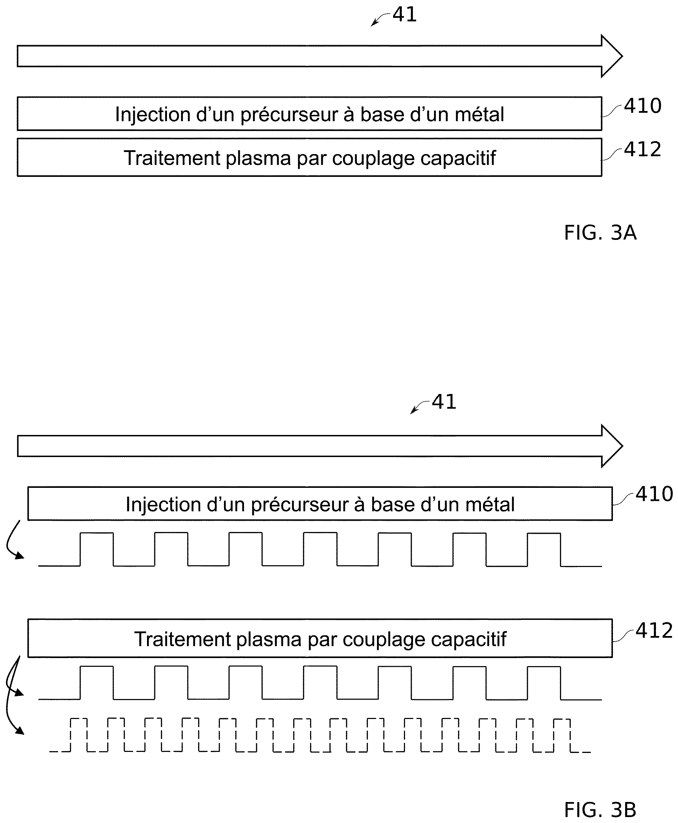

Comme par exemple illustré par la figure 3A, le cycle 41 peut comprendre une injection 410 d'un précurseur à base d'un métal. Simultanément à cette injection, le traitement plasma 412 peut avoir lieu.

Selon un exemple, l'injection et/ou le traitement plasma peuvent être continus. Selon un exemple, l'injection 410 et/ou le traitement plasma 412 peuvent être intermittents dans un cycle 41. L'utilisation d'impulsions, et notamment de pulses de précurseurs, peut permettre de moduler les mécanismes de croissance. Ces impulsions sont particulièrement avantageuses pour le dépôt de couche métallique, et notamment pour la création de liaisons pendantes, par plasma H₂/Ar ou Ar seul. Il est en effet plus difficile de former ce type de couche par rapport à des oxydes/nitrures/sulfures qui sont beaucoup plus faciles à former par réactivation des ligands (substitution chimique).

Comme illustré par la figure 3B, le traitement plasma 412 peut comprendre plusieurs impulsions plasma. Dans un cycle 41, l'application de la puissance radiofréquence au plateau 110 peut être intermittente de façon à ne générer le plasma que par intermittence, c'est-à-dire que le traitement plasma 412 peut comprendre des phases d'application de la puissance RF séparées par des phases de non-application de la puissance RF au plateau 110. De façon similaire, l'injection 410 peut être intermittente, c'est-à-dire que l'injection 410 peut comprendre des phases d'injection du précurseur à base d'un métal dans la chambre 10 séparées par des phases de non-injection du précurseur dans la chambre 10. Les phases respectivement d'application de la puissance RF et d'injection forment les impulsions. Comme l'illustre la figure 3B, ces impulsions peuvent être simultanées entre l'injection 410 et le traitement plasma 412. De façon alternative comme illustré en pointillé en figure 3B, ces impulsions peuvent être décalées dans le temps.

Notons que cet exemple d'impulsions plasma et/ou d'impulsions lors de l'injection d'un précurseur peut s'appliquer pour l'injection d'un précurseur à base d'un deuxième métal 413a. Cela peut s'appliquer pour une partie seulement des injections 410, 413a ou pour chaque injection 410, 413a d'un cycle 41.

De préférence le traitement plasma 412 et injection d'un précurseur 410, 413a sont chacun fait par impulsions simultanées ou séquentielles. Par « séquentielle » on entend que les impulsions ne sont pas complètement simultanées entre l'injection et le traitement plasma, et de préférence les impulsions ne se recoupent pas temporellement entre l'injection et le traitement plasma. Ceci permet une réduction in situ du précurseur soit en phase gazeuse soit au niveau des adsorbats sur la couche exposée 20 du substrat 2. La durée des impulsions peut être sensiblement identique entre injection 410,413a et le traitement plasma 412 ou bien ces durées peuvent être indépendantes. Ce mode est autolimitant avec le déphasage entre l'impulsion du précurseur et le traitement plasma. Comme le précurseur métallique ne réagit pas avec lui-même, une fois que la surface du substrat est saturée par les adsorbats, plus aucune réaction ne peut se produire. Le traitement plasma permet de réduire les ligands des adsorbats, et un nouveau pulse de précurseur métallique peut de nouveau engendrer de nouveaux adsorbats, par libération de sites d'ancrage. Les durées d'impulsion pour l'injection du précurseur et pour le traitement plasma peuvent être adaptés selon les cas, et notamment en fonction de la détente subie par le précurseur à son entrée dans la chambre. Par exemple, la durée d'injection du précurseur peut être ≤1 s d'ouverture et la durée du plasma peut être ≤ à 20 s.

De préférence, lorsque qu'un précurseur à base d'un métal est injecté par impulsion, le précurseur comprend le métal et des ligands alkyls. Le ligand est de préférence non halogéné, car un ligand halogéné peut possibilité endommager les parois du réacteur en formant une chimie gravante. De plus, les halogènes étant fortement électronégatifs, ils renforcent la liaison Métal-Halogène, ce qui rend la création de liaisons pendantes d'autant plus difficile.

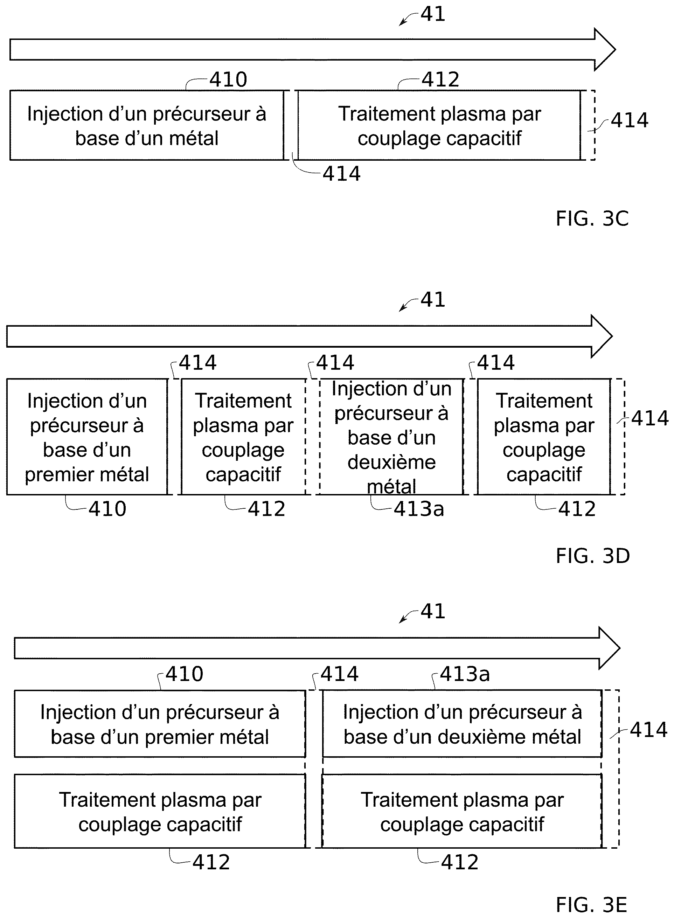

Selon exemple, comme illustré par les figures 3C et 3D, une injection d'un précurseur à base d'un métal 410,413a peut être suivie par un traitement plasma 412. Cela peut s'appliquer pour l'injection du précurseur à base du premier métal 410 comme l'illustre la figure 3C, et/ou pour l'injection du précurseur à base d'un deuxième métal 413a comme l'illustre la figure 3D.

Comme l'illustre la figure 3E, lorsque le cycle 41 comprend plusieurs injections de précurseur à base d'un métal 410, 413a, chaque injection peut être faite simultanément à un traitement plasma 412, une injection et le traitement plasma associé 412 étant séparés de l'injection 413a et du traitement plasma 412 suivant par une phase de purge 414.

Notons que des combinaisons de ces exemples sont possibles, avec par exemple une injection d'un précurseur à base d'un premier métal 410 simultanément à un traitement plasma 412, suivie d'une injection d'un précurseur à base d'un deuxième métal 413a elle-même suivie d'un traitement plasma 412.

Selon un exemple le traitement plasma 412 peut comprendre une injection d'argon en mélange avec du dihydrogène dans la chambre de réaction 10, par exemple lorsque le traitement plasma 412 suit l'injection d'un précurseur à base d'un premier métal comme illustré en figure 3C. Lorsque le plasma est généré, le traitement plasma 412 peut ne pas comprendre d'injection de d'hydrogène dans la chambre 10 de réaction. En effet, lors du développement de l'invention il a été mis en évidence qu'il n'était pas nécessaire d'injecter dans la chambre un gaz réducteur tel que le d'hydrogène pour réduire le métal déposé. Les propriétés du plasma généré par couplage capacitif conjuguées à l'injection du ou des précurseur(s) métallique(s) suffisent à faire croître une couche métallique sur la surface exposée 20 du substrat 2. Ceci est notamment le cas lorsque l'injection 410,413a et le traitement plasma 412 sont simultanés, et surtout lorsque le précurseur métallique contient des ligands de type alkyl. Lorsque le traitement plasma 412 et/ou injection d'un précurseur 410,413a sont faites par impulsion, le traitement plasma comprend néanmoins de préférence une injection de dihydrogène dans la chambre de réaction 10. En injection simultanée, il est préférable d'éviter un plasma réactif (par exemple à base d'H₂) au risque de détruire le précurseur et on aura une croissance de type CVD (i.e. non couche/couche, car non autolimitée). En mode séquentiel, on peut se permettre d'utiliser un plasma réactif, car seuls les ligands des adsorbats seront traités par ce plasma.

En ce qui concerne les paramètres de génération du plasma, pour la croissance de couche métallique, de préférence ces paramètres sont choisis de façon à modifier et/ou éliminer les ligands du précurseur pour favoriser le dépôt d'une couche métallique par adsorption métal sur métal. Pour cela la puissance de la polarisation radiofréquence peut être inférieure ou égale à 80 W, la pression dans la chambre de réaction 10 peut être inférieure ou égale à 80 mTorr, et la durée du traitement plasma au cours d'un cycle 41 peut être inférieure ou égale à une minute. La dose déposée est ainsi limitée ce qui améliore l'élimination du ligand sans risquer d'enlever le métal déposé.

En ce qui concerne la nature du métal, ce procédé est particulièrement adapté pour le dépôt des métaux titane, tantale, aluminium, argent, zinc, ruthénium, platine, cuivre.

Le précurseur à base du premier métal et le précurseur à base du deuxième métal sont de préférence des précurseurs organométalliques dédiés aux procédés ALD. Le procédé peut être adapté selon le précurseur métallique. Par exemple, pour un précurseur métallique chloré, on choisira de préférence un plasma N₂/H₂. Pour un précurseur organométallique, on choisira plutôt un plasma inerte, et notamment un plasma Ar, pour retirer le ligand organique.

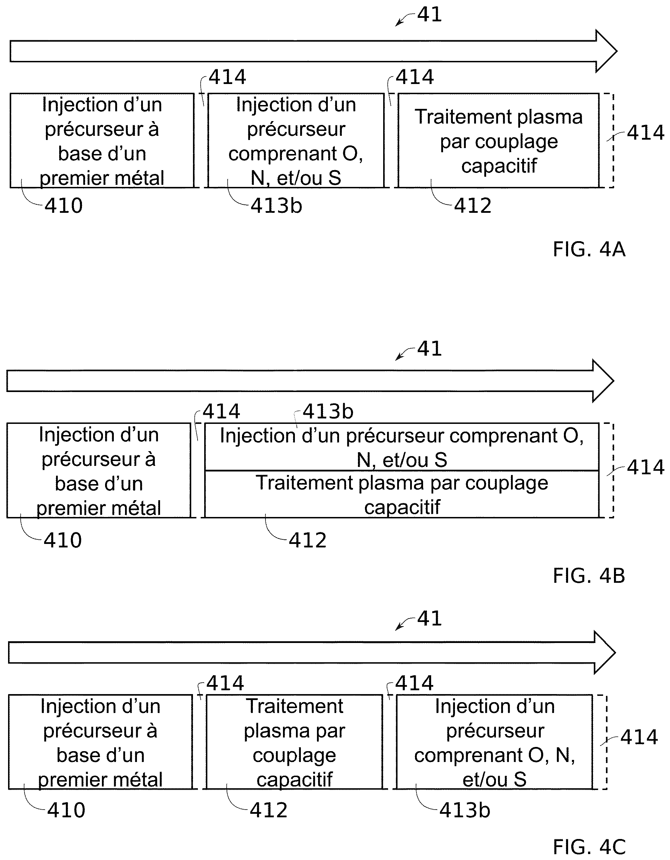

Des exemples de dépôt sont maintenant décrits, en référence aux figures 4A à 4C.

Afin de déposer une couche d'oxyde, de nitrure et/ou de sulfure d'un métal sur la surface exposée 20, le procédé comprend l'injection d'un précurseur à base d'un métal 410 et une injection d'un précurseur comprenant l'un au moins parmi les éléments oxygène, azote et soufre 413b. De préférence, dans un cycle 41, l'injection du précurseur à base d'oxygène, d'azote et/ou de soufre 413b suit l'injection du précurseur à base de métal 410. Le traitement plasma 412 peut être effectué avant et/ou simultanément à et/ou après l'injection du précurseur à base d'oxygène, d'azote et/ou de soufre 413b. Ainsi la quantité et la réactivité du précurseur à base d'oxygène, d'azote et/ou soufre sont limitées de façon à moduler la réactivité de surface avant l'injection du précurseur à base de métal 410 du cycle 41 suivant. Selon l'ordre relatif entre le traitement plasma 412 et l'injection du précurseur à base d'oxygène, d'azote et/ou de soufre 413b, ce précurseur peut être désigné par le terme « réactant thermique » lorsque le traitement plasma 412 suit l'injection 413b, ou « réactant plasma » lorsque le traitement plasma 412 est simultané à l'injection 413b.

Comme l'illustre la figure 4A par exemple, l'injection du précurseur à base de métal 410 peut être suivie de l'injection du précurseur à base d'oxygène, d'azote et/ou de soufre 413b, elle-même suivie du traitement plasma 412. Selon cet exemple, le précurseur à base d'oxygène, d'azote et/ou de soufre peut être choisi parmi le groupe constitué de H₂O, O₂, NH₃, ou O₃ avec un ozoneur. Le précurseur métallique peut être traité thermiquement par le deuxième précurseur avant le traitement plasma 412. Le traitement plasma 412 peut-être à base d'argon.

Selon un deuxième exemple, par exemple illustré par la figure 4B, l'injection du précurseur à base de métal 410 peut être suivie de l'injection du précurseur à base d'oxygène, d'azote et/ou de soufre 413b, elle-même faite simultanément au traitement plasma 412. Selon cet exemple le précurseur à base d'oxygène, d'azote et/ou de soufre peut être choisi parmi le groupe constitué de O₂, N₂, NH₃ et H₂S. Les précurseurs H₂O et O₃ ne sont pas utilisés par non plasmagène. Dans le cas de H₂S, un traitement par plasma simultané est nécessaire pour activer l'énergie de réaction. Une couche respectivement d'oxyde, de nitrure ou de sulfure de métal est donc déposée de préférence lorsque l'injection du deuxième précurseur 413b est simultanée au traitement plasma 412. Le précurseur à base d'oxygène, d'azote et/ou de soufre peut être injecté 413b avec de l'argon.

Selon un troisième exemple, illustré par la figure 4C, l'injection du précurseur à base de métal 410 peut être suivie par le traitement plasma 412, ce dernier étant suivi de l'injection du précurseur à base d'oxygène et/ou d'azote, et/ou de soufre dans le cas où un traitement plasma est aussi fait simultanément à l'injection de soufre 413b.

Les deux régimes de traitement plasma 412 décrits précédemment peuvent être utilisés pour le dépôt d'une couche d'oxyde, de nitrure et/ou de sulfure. Selon un premier exemple, la puissance de la polarisation radiofréquence peut être inférieure ou égale à 80 W, la pression dans la chambre de réaction peut être inférieure ou égale à 80 mTorr, et la durée du traitement plasma au cours d'un cycle de dépôt peut être inférieure ou égale à 1 minute. Ces paramètres permettent de jouer sur la réactivité de surface entre le précurseur à base de métal, le précurseur à base d'oxygène, d'azote et/ou de soufre (réactant thermique ou plasma), ainsi que les radicaux du plasma.

Selon un deuxième exemple, la puissance de la polarisation radiofréquence peut être supérieure ou égale à 50 W, la pression dans la chambre de réaction peut être inférieure ou égale à 20 mTorr, et la durée du traitement plasma au cours d'un cycle de dépôt peut être supérieure ou égale à 1 minute. Ainsi, ici encore, le précurseur chimisorbé à la surface peut être retiré. Le matériau déposé peut ainsi croître sur des portions de couches localisées. Ces conditions permettent donc un dépôt sélectif, par exemple sur du substrat 3D.

Selon un exemple le précurseur à base de métal comprend le métal et un groupement aminé. Dans le cas de précurseur aminé, un ajustement de la dose (durée et énergie du flux d'ions) par les paramètres du plasma, permet de désorber le ligand du métal afin de déposer la couche atomique de métal, mais également de casser la liaison N-C du ligand pour faciliter le dépôt de nitrure. Par exemple, le précurseur peut présenter l'une des formules chimiques ci-dessous.

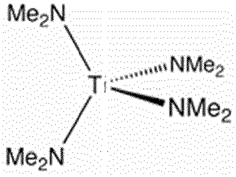

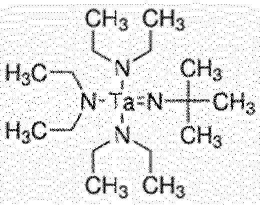

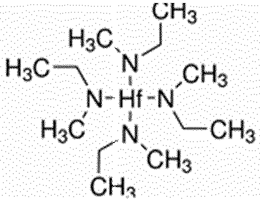

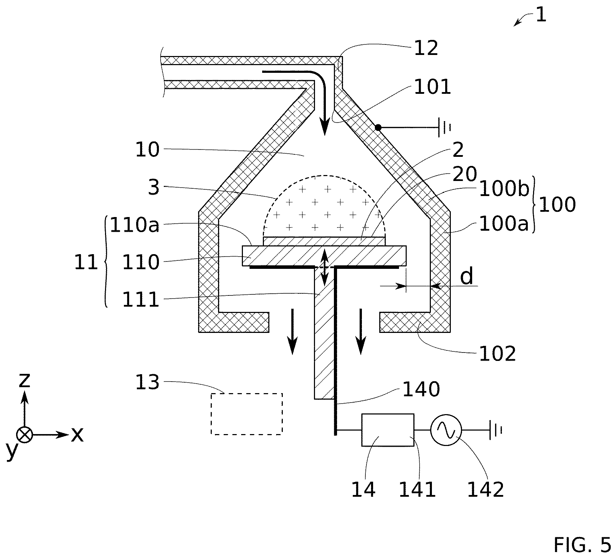

Des exemples de réacteur 1 sont maintenant décrits en référence aux figures 5 à 8. Des paramètres de traitement plasma 412 sont en outre décrits.

Le réacteur 1 est plus particulièrement destiné au dépôt par couche atomique assisté par plasma.

Le réacteur 1 comprend une chambre 10 de réaction destinée à accueillir un substrat 2 et dans laquelle le dépôt est destiné à être effectué. Cette chambre 10 est délimitée par une ou plusieurs parois latérales 100, une paroi supérieure 101 et une paroi inférieure 102.

Pour effectuer le dépôt d'une couche sur le substrat 2, le réacteur 1 comprend des moyens d'arrivée et d'évacuation de précurseur(s) gazeux et/ou d'espèce(s) gazeuse(s) pour la formation du plasma. Le réacteur 1 comprend une arrivée de précurseur gazeux 12 configurée pour amener des précurseurs gazeux dans la chambre 10, comme l'illustre la flèche en haut du réacteur dans les figures 5 à 8. L'arrivée de précurseur gazeux 12 peut en outre être configurée pour introduire dans la chambre 10 des gaz pour la formation du plasma, par exemple des gaz rares tel que l'hélium ou l'argon. Le réacteur 1 comprend en outre un module de pompage 13 de la chambre 10. Le module de pompage 13 permet d'évacuer les espèces gazeuses présentent dans la chambre, comme l'illustre les deux flèches en bas du réacteur dans les figures 5 à 8. Ces espèces peuvent notamment être évacuées entre différents cycles du dépôt ALD. Le module de pompage 13 permet en outre, avec l'arrivée 12, de maintenir une pression donnée à l'intérieur de la chambre 10, typiquement inférieure à la pression atmosphérique.

Le substrat 2 est accueilli dans la chambre 10 de réaction par un porte-échantillon 11. Le porte-échantillon peut comprendre un plateau 110 configuré pour recevoir le substrat 2, relié à un bras 111. Le plateau 110 peut notamment présenter une face supérieure 110a plane supportant le substrat 2. La face supérieure 110a est par exemple sensiblement horizontale. Notons que le plateau 110 peut avoir d'autres faces inclinées, par exemple sur les bords ou une face inférieure arrondie.

Le réacteur 1 est configuré de sorte qu'un plasma soit généré par couplage capacitif entre la face supérieure 110a du plateau 110 et la paroi latérale 100, polarisée à la masse comme illustrée sur les figures 5 à 8. Pour cela, le plateau 110 est électriquement conducteur. Le plateau 110 peut être au moins en partie formé d'un matériau électriquement conducteur. La paroi latérale 100 est au moins en partie électriquement conductrice. La paroi latérale 100 peut être au moins en partie formée d'un matériau électriquement conducteur. Le réacteur 1 comprend en outre une source de puissance 14 configurée pour appliquer une puissance radiofréquence au plateau 110. La source de puissance 14 peut par exemple comprendre un générateur de puissance radiofréquence 142 relié à un organe de transmission 140 de la radiofréquence au plateau 110.

Cette source de puissance 14 peut comprendre un dispositif de régulation 141 et permet d'induire une tension RF, aussi appelée tension d'auto-polarisation, sur le plateau 110 pour générer le plasma CCP. De préférence ce dispositif de régulation 141 comprend une unité d'adaptation automatique (qualifiée par son vocable anglais d'auto match unit) qui adapte l'impédance du plasma dans la chambre 10 à celle du générateur de puissance radiofréquence 142 de façon à minimiser la puissance réfléchie et permettre l'auto-entretien de la décharge. Cette source de puissance 14 est configurée pour générer le plasma et permettre l'auto-polarisation du plateau 110. En effet, le plasma est alimenté en puissance, et l'unité d'adaptation (ou de façon équivalente boite d'accord) adapte l'impédance pour minimiser la puissance réfléchie et permettre l'auto-entretien de la décharge. Le plasma est une décharge électrique possédant sa propre impédance fonction de son degré d'ionisation et de la chimie des gaz, ainsi que des paramètres géométriques du réacteur et d'alimentation électrique. La tension d'auto-polarisation peut typiquement être de 50 V à 300 V pour une puissance variant de 10 W à 100 W dans un réacteur recevant des substrats de diamètre maximal 200 mm. Le dispositif de régulation 141 peut notamment comprendre un atténuateur configuré pour limiter la puissance du générateur 142.

La paroi latérale 100 est au moins en partie non parallèle à la face supérieure 110a du plateau 110. La face supérieure 110a du plateau 110 et la paroi latérale 100, au moins sur sa partie non parallèle à la face supérieure du plateau, sont séparées d'une distance d configurée de façon à générer un plasma par couplage capacitif entre le plateau 110 et la paroi latérale 100, jouant chacun le rôle d'électrode pour la génération du plasma. Lors du développement de l'invention, il a en effet été mis en évidence qu'une disposition non parallèle de la paroi latérale 100 et de la face supérieure 110a, couplée à une certaine distance d, permettait de générer le plasma par couplage capacitif à proximité du substrat 2, au niveau d'une zone de génération du plasma 3.

Le plasma est ainsi généré de façon localisée au voisinage 3 du substrat 2 avec un flux ionique beaucoup plus faible que pour un réacteur CCP conventionnel. Ce réacteur 1 permet de tirer bénéfice du bombardement ionique de faible énergie pour améliorer les propriétés du matériau (densité, pureté, structure cristalline, contrainte interne). De plus, comme présenté précédemment en référence au procédé 4, cela ouvre de nouvelles voies de développement de procédés concernant les métaux, les oxydes, les nitrures et les sulfures sur des substrats 2D et 3D, ainsi que des procédés de dépôts sélectifs de surface et topographiques. Ce réacteur 1 permet donc d'effectuer des dépôts de nature variée, contrairement aux réacteurs existants qui sont plus limités. Ce mode de génération du plasma permet en effet de faire des dépôts de couche métallique, notamment de métaux de transition et/ou de terres rares. Des dépôts de couche d'oxyde, de nitrures et/ou de sulfure sont en outre possibles, notamment de métaux de transition et/ou de terres rares.

La distance d permettant l'auto-entretien de la décharge plasma est dictée par la loi de Paschen, fonction de la pression P dans le réacteur, et de la tension moyenne minimale Uₘᵢₙ d'auto-polarisation RF : Uₘᵢₙ = P.d. On comprend donc que la distance d peut varier en fonction de la pression P dans la chambre 10 et de la tension moyenne minimale Uₘᵢₙ imposée par la source de puissance 14.

Cette distance d est la distance la plus courte entre les deux électrodes que forment le plateau 110 et la paroi latérale 100. Cette distance peut par exemple être la distance entre l'un ou les deux bords d'extrémité du plateau 110 et la paroi latérale 100, et plus particulièrement entre l'un ou les deux bords d'extrémité de la face supérieure 110a du plateau 110 et la paroi latérale 100, de préférence entre une face supérieure du plateau 110 et la paroi latérale 100, et plus particulièrement entre l'un ou les deux bords d'extrémité de la face supérieure 110a du plateau 110 et la paroi latérale 100. Lors de la génération du plasma, le plateau 110 et la paroi latérale 100 sont éloignés de l'un à l'autre de la distance d.

Selon un exemple, la distance d entre la face supérieure 110a du plateau 110 et la paroi latérale 100 est comprise entre 5 cm et 15 cm, de préférence entre 5 cm et 12 cm, et plus préférentiellement encore entre 5 et 8 cm. Cette gamme de distance d est par exemple valable pour une pression P 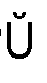 ≤ 80 mTorr (avec 1 mTorr = 10⁻³ Torr et 1 Torr ≈ 133,322 Pa), et Umin (tension d'auto-polarisation) dont la valeur absolue est sensiblement comprise entre 0 V exclu et 300 V ]0 V ; 300 V], de préférence entre 50 V et 300 V [50 V ; 300 V], et plus préférentiellement encore entre 100 V et 300 V. Une densité d'ions suffisamment faible, sensiblement inférieure ou égale à 10¹⁴ cm⁻².s⁻¹, peut ainsi être obtenue.

Pour le dépôt ALD par couplage capacitif selon l'invention, les pressions sont de l'ordre du mTorr à quelques centaines de mTorr, par exemple 200 mTorr. La puissance radiofréquence typiquement appliquée est inférieure ou égale à 100 W, cette puissance étant non nulle. Les paramètres de pression, de tension d'auto-polarisation et de distance sont interdépendantes pour obtenir la génération d'un plasma par couplage capacitif. Comme il sera décrit plus en détail ultérieurement, il est possible dans le réacteur 1 que d soit fixée, et que la tension d'auto-polarisation et la pression soient ajustées dans des gammes correspondantes ci-dessus. En alternative, la distance d peut être ajustable par exemple avec des moyens de réglage de la hauteur du plateau 110, comme décrit ultérieurement.

Notons que le type de gaz peut avoir une influence sur la loi de Paschen. Ces données sont tabulées et connues de l'homme du métier, comme par exemple décrit pour l'argon dans C. Torres, P. G. Reyes, F. Castillo, H. Martinez, Journal of Physics: Conference Series; Bristol Vol. 370, N° 1, (Jun 2012*).* L'homme du métier saura donc adapter ces paramètres par exemple en ajustant la tension d'auto-polarisation et la pression, d étant fixée, voire en complément en ajustant la distance d, notamment dans les gammes précitées.

Afin de générer le plasma, la paroi latérale 100 électriquement conductrice peut être au moins en partie disposée au-dessus du plateau 110, en projection de ladite paroi sur un plan perpendiculaire à la face supérieure 110a du plateau 110. On comprend donc que au moins une partie de la paroi 100 est disposée en regard de la face supérieure du plateau, de sorte que le plasma par couplage capacitif peut être généré entre la paroi latérale 100 et la face supérieure 110a du plateau 110, sur laquelle le substrat 2 est placée.

Selon un exemple, la chambre de réaction 10 et plus particulièrement la paroi latérale 100 présente une symétrie de révolution autour d'une direction parallèle à l'axe z et sensiblement centrée par rapport à la face supérieure 110a du plateau 110. Cette symétrie permet un amorçage du plasma sur toute la surface de la face supérieure 110a du plateau 110. Dès l'allumage du plasma, celui-ci se propage sur l'ensemble de l'électrode inférieure (la face supérieure 110a du plateau 110). Le plasma est donc plus homogène.

Selon un exemple, la paroi latérale 100 est disposée de façon verticale par rapport au plan d'extension principale (x, y) de la face supérieure 110a du plateau 110. Une paroi verticale engendre toutefois des lignes de champ très serrées sur les bords du substrat, et donc un plasma plus localisé (et donc plus énergétique). Un plasma plus localisé peut générer des phénomènes de claquage aux bords du substrat et donc des effets de bords.

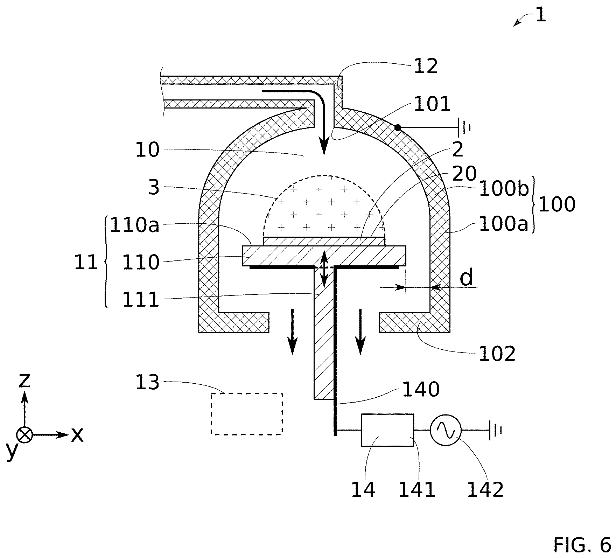

Pour limiter cela, comme l'illustrent les figures 5 et 6, la paroi latérale 100 est de préférence au moins en partie disposée de façon oblique par rapport au plan d'extension principale (x, y) de la face supérieure 110a du plateau 110. De façon équivalente, la paroi latérale est disposée ni parallèlement ni perpendiculairement au plan d'extension principale (x, y) de la face supérieure 110a. Cette disposition oblique permet notamment d'améliorer le plasma obtenu en limitant les effets de bord. Le plasma généré est ainsi rendu plus homogène pour un meilleur dépôt de couche.

La paroi latérale 100 peut comprendre plusieurs portions 100a, 100b. Une première portion 100a peut être disposée sensiblement perpendiculairement au plan d'extension principale (x, y) de la face supérieure 110a. Une deuxième portion 100b peut être disposée de façon oblique par rapport au plan d'extension principale (x, y) de la face supérieure 110a du plateau 110. Dans la suite, on considère à titre non limitatif que la portion 100b de la paroi latérale est disposée de façon oblique par rapport au plan (x, y).

Comme par exemple illustré par la figure 5, la deuxième portion 100b de la paroi latérale 100 peut présenter une géométrique conique au-dessus du plateau 110. Cette géométrie peut plus particulièrement être choisie en fonction de la distance d. La portion 100b peut par exemple être sous la forme d'un cône tronqué par la paroi supérieure 101. Une géométrie de cône tronqué permet que la paroi latérale ne forme pas de creux dans lequel les espèces générées par le plasma pourraient s'accumuler. De préférence, la deuxième portion 100b présente une géométrie conique d'axe de révolution sensiblement centré par rapport au plateau 110.

Comme par exemple illustré par la figure 6, la deuxième portion 100b de la paroi latérale 100 peut former un dôme au-dessus du plateau 110. La portion 100b peut par exemple être sous la forme d'une demi-sphère au-dessus du plateau 110. À nouveau, cette géométrie peut plus particulièrement être choisie en fonction de la distance d. Une géométrie en forme de dôme, et plus particulièrement une géométrique hémisphérique permet d'avoir un volume de chambre plus faible (donc moins de réactifs consommés, chambre plus facile à pomper, et de limiter le volume mort dans la chambre. De préférence, la deuxième portion 100b présente une géométrie hémisphérique, de préférence sensiblement centrée par rapport au plateau 110. Le dôme peut être tronqué par la paroi supérieure 101. En alternative la paroi latérale 100 peut former un dôme non tronqué.

On comprend, par exemple en référence à la géométrie en dôme décrite ci-dessus, que la paroi latérale 100 peut s'étendre de façon à former tout ou partie de la paroi supérieure 101.

Selon un exemple, le plateau 110 peut être non ajustable en hauteur dans la chambre 10. De façon équivalente, le plateau 110 peut être non mobile au moins selon la direction verticale z dans la chambre 10. On peut prévoir toutefois que le plateau 110 soit configuré pour être mobile, par exemple en rotation, à la hauteur fixée de la chambre 10, par exemple pour améliorer l'uniformité du dépôt. Cette rotation peut être autour de l'axe de son bras 111. Le plateau 110 peut en alternative être totalement fixe dans la chambre 10. Notamment lorsque le plateau 110 est non ajustable en hauteur, la géométrie de la paroi latérale 110 peut être adaptée par rapport au porte-échantillon pour obtenir la distance d permettant la génération du plasma. Le réacteur 1 peut ainsi être de configuration simplifiée, et donc moins onéreux.

Selon un autre exemple, le plateau 110 peut être ajustable en hauteur dans la chambre 10, comme l'illustre la double flèche verticale dans les figures 5 à 8. De façon équivalente, le plateau 110 peut être mobile au moins selon la direction verticale z dans la chambre 10. Ainsi, la distance d peut être ajustée par la hauteur du plateau 110, par exemple pour différentes valeurs de pression ou de tension minimale Uₘᵢₙ, selon les besoins. On peut en outre moduler les propriétés du plasma en ajustant la hauteur du plateau 110 tout en veillant à ne pas éteindre le plasma 3. L'ajustement en hauteur du plateau 110 peut en outre être particulièrement avantageux lorsque le réacteur 1 comprend une source additionnelle de plasma, comme décrit plus en détail ultérieurement. On peut prévoir en outre que le plateau 110 soit configuré pour être mobile, par exemple en rotation, par exemple pour améliorer l'uniformité du dépôt. Cette rotation peut ici encore être autour de l'axe de son bras 111.

Le ou les mouvement(s) du plateau 110 peut/peuvent par exemple être actionné(s) par un moteur, non représenté sur les figures.

Comme par exemple décrit par les figures 5 et 6, le réacteur 1 peut être configuré pour ne former que le plasma par couplage capacitif entre le plateau 110 et la paroi latérale 100 dans la chambre de réaction. Le plasma peut notamment être généré entre deux électrodes uniquement. Le plateau 110 peut constituer l'une des électrodes. La paroi latérale 100 peut constituer l'autre électrode. Le réacteur 1 peut ne comprendre que la génération par couplage capacitif entre le plateau 110 et la paroi latérale 100 comme source de plasma. La configuration du réacteur 1 est ainsi simplifiée, et donc moins onéreuse. Notons que l'ajustement ou non en hauteur du plateau 110 est possible selon cet exemple.

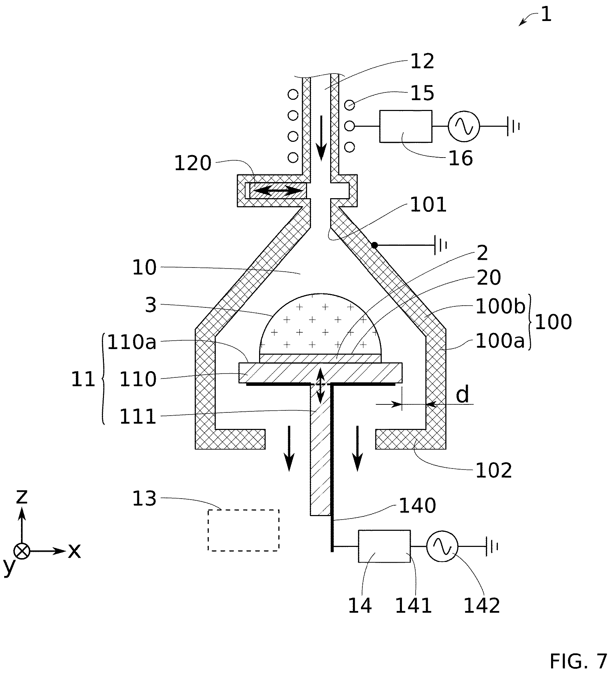

Comme par exemple illustré par la figure 7, le réacteur 1 peut comprendre une source plasma à couplage inductif 15 déportée de la chambre 10. Le réacteur 1 peut donc être un réacteur multimode ICP et/ou CCP. Selon les besoins, le plasma peut être généré en mode ICP et/ou en mode CCP. Pour cela, le réacteur 1 peut comprendre une source inductive radiofréquence comprenant une bobine 15 alimentée par un dispositif de génération de puissance radiofréquence 16. La source de puissance 14 et la source inductive 15, 16 sont configurées de sorte que la puissance RF appliquée au plateau 110 est indépendante de la puissance RF de la source inductive.

Lorsque le réacteur 1 fonctionne en mode CCP, la génération du plasma se produit par couplage capacitif entre la face supérieure 110a du plateau 110 et la paroi latérale 100 comme décrit précédemment. Lorsque le réacteur 1 fonctionne en mode ICP, la génération du plasma est faite par la source plasma à couplage inductif 15. La source de puissance 14 peut alors être utilisée comme dispositif de polarisation configuré pour induire une tension de polarisation au substrat 2 permettant l'extraction des ions du plasma déporté avec une énergie incidente contrôlée au moment où ils arrivent au voisinage du substrat 2.

L'arrivée des précurseurs gazeux 12 peut être disposée au niveau de la source inductive 15, 16. La source inductive 15, 16 peut être isolée de la chambre 10 par une vanne 120 présentant une configuration ouverte de passage des espèces du plasma de la source à la chambre 10, et une configuration fermée de blocage de ces espèces. Notons qu'on peut prévoir qu'une autre arrivée de précurseurs gazeux soit disposée directement au niveau de la chambre 10, sans passer par la source inductive.

De préférence, lorsque le réacteur 1 peut comprendre une source plasma à couplage inductif 15 déportée de la chambre 10, le plateau 110 est réglable en hauteur. Ainsi, selon la distance d obtenue entre le plateau 110 et la paroi latérale 100, on peut générer un plasma par la source inductive 15, 16 uniquement, ou à la fois par la source inductive 15, 16 et par le couplage capacitif entre le plateau 110 et la paroi latérale 100. Notons qu'un ajustement ou non en hauteur du plateau 110 est possible selon cet exemple.

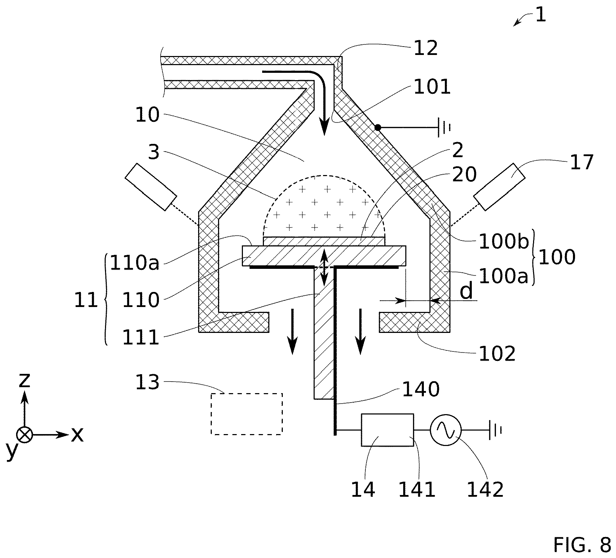

Comme l'illustre par exemple la figure 8, le réacteur 1 peut comprendre en outre un module de détermination 17 de l'épaisseur de la couche déposée. Ce module 17 peut par exemple comprendre un ellipsomètre couplé au réacteur 1, par exemple à sa paroi latérale 100. La figure 8 est une représentation de principe. En pratique, les deux points d'intersection des rayons émis et réfléchis se coupent sur la surface du substrat où la croissance a lieu.

Des exemples de paramètres de fonctionnement du réacteur 1 sont maintenant décrits.

Les conditions de puissance RF et de pression dans la chambre 10 permettent d'adapter finement des caractéristiques du flux ionique du plasma.

L'arrivée de précurseurs gazeux 12 et le module de pompage 13 peuvent être configurés pour maintenir, au moins lors du traitement plasma 412, une pression sensiblement comprise entre 5 et 200 mTorr, de préférence comprise entre 5 mTorr et 100 mTorr, de préférence comprise entre 5 mTorr et 80 mTorr dans la chambre 10 de réaction. De préférence, la pression dans la chambre de réaction est sensiblement inférieure ou égale à 100 mTorr au moins lors du traitement plasma 412.

La source de puissance 14 peut être configurée pour appliquer la puissance radiofréquence avec une puissance inférieure ou égale à 100 W.

La source de puissance 14 peut être configurée pour appliquer la puissance radiofréquence avec une fréquence comprise entre 2 et 100 MHz lorsque le plasma est généré par couplage capacitif.

Notons que lorsque le réacteur comprend une source plasma à couplage inductif 15, et fonctionne en mode ICP, la source de puissance jouant le rôle de dispositif de polarisation configuré pour induire une tension de polarisation au substrat 2 peut opérer à une puissance supérieure et/ou à une fréquence autre que la gamme précisée ci-dessus.

Ces paramètres dans les gammes indiquées ci-dessus permettent d'obtenir les caractéristiques de flux ionique suivantes du plasma généré entre la paroi latérale 100 et le plateau 110, adaptées au dépôt PEALD :
- densité de puissance : 0,05 à 0,5 W/cm²
- flux ionique : 10¹² à 10¹⁴ ions/(cm².s)
- énergie des ions : 0 à 300 eV (avec 1 eV ≈ 1,60218.10⁻¹⁹ J).

Le tableau suivant décrit des exemples de paramètres de génération de plasma selon l'invention, pour un plasma Argon, sans source déportée ICP. La distance d correspondant à ces mesures est comprise entre 5 et 6 cm.

**Tableau 1**

| Gaz | Ar | Ar | Ar | Ar | Ar | Ar | Ar | Ar | Ar | Ar |
|---|---|---|---|---|---|---|---|---|---|---|
| Flux (sccm ou cm³ standard/min) | 60 | 60 | 60 | 60 | 60 | 60 | 60 | 60 | 60 | 60 |
| Pression (mTorr) | 7 | 7 | 7 | 7 | 7 | 7 | 7 | 7 | 7 | 7 |
| Puissance RF appliquée (W) | 1 | 2 | 3 | 5 | 7 | 8 | 9 | 10 | 70 | 80 |
| Vdc sond (V) | 0 | 0 | 0 | 0 | 0 | 56 | 61 | 67 | 222 | 253 |
| Vdc flexal (V) | 0 | 0 | 0 | 0 | 0 | 56 | 62 | 68 | 233 | 241 |

Les paramètres Vdc sonde et flexal donnent la tension d'auto-polarisation, correspondant à l'adaptation d'impédance entre le plasma et la boite d'accord du réacteur. Vdc sonde donnée par une mesure de sonde (qui permet de déterminer le flux ionique) et Vdc flexal est donnée directement par la boite d'accord du réacteur. Le réacteur est alimenté en puissance RF appliquée et la tension d'auto-polarisation reste nulle quand le plasma ne s'allume pas ou ne s'autoentretient pas. Dans ce cas, toute la puissance est emmagasinée dans la boite d'accord.

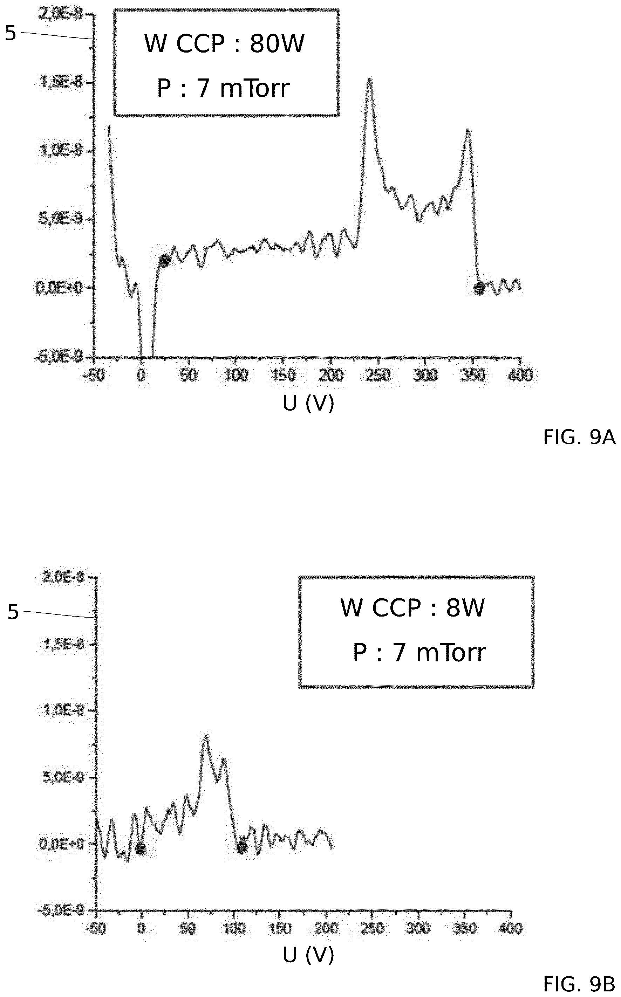

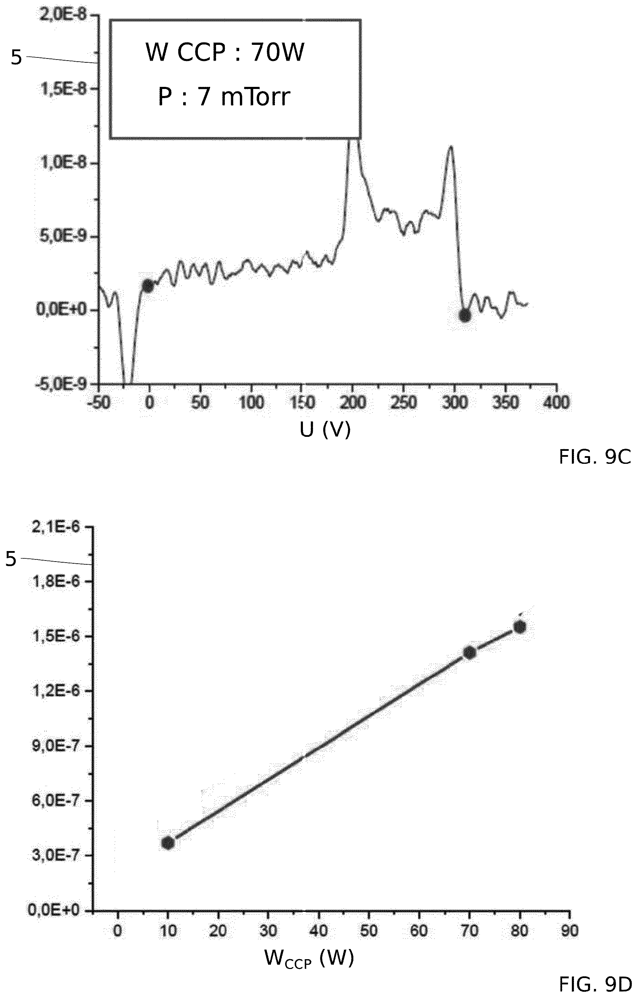

Les figures 9A à 9D décrivent, pour les exemples de paramètres du Tableau 1, l'effet de la puissance RF W_{CCP} appliquée au plateau 110 sur le flux d'ions générés 4 (en unité arbitraire), à pression P constante, et en fonction de la tension d'auto-polarisation U.

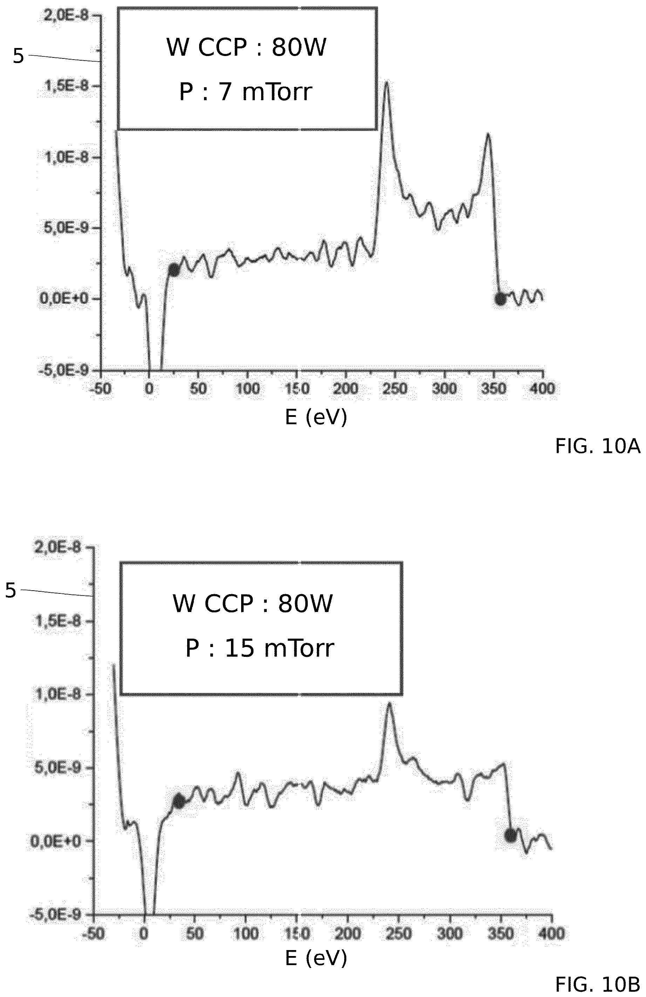

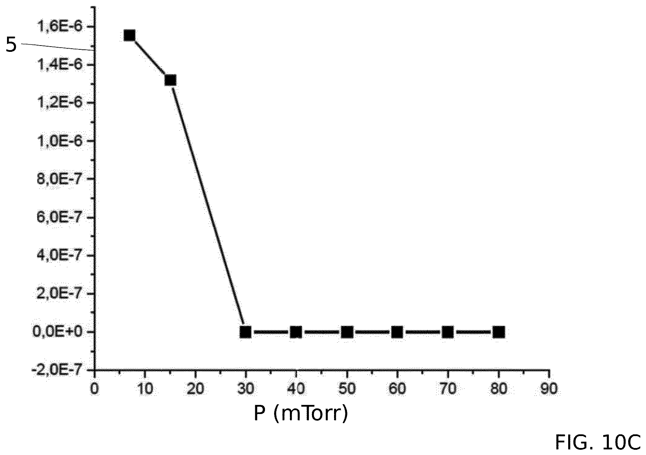

Les figures 10A à 10C décrivent, pour les exemples de paramètres du Tableau 1, l'effet de la pression P appliquée au plateau 110 sur le flux d'ions générés 4 (en unité arbitraire), à puissance RF W_{CCP} appliquée au plateau 110 constante, et en fonction de la tension d'auto-polarisation U, et en fonction de l'énergie des ions E.

Au vu de la description qui précède, il apparaît clairement que l'invention propose une solution améliorée de dépôt assisté par plasma. Le procédé est amélioré notamment en termes de nature de couche déposée et/ou de sélectivité du dépôt. Le procédé PEALD permet un meilleur contrôle du bombardement ionique, et notamment une assistance du plasma plus douce que les solutions existantes, et donc qui engendre moins de défauts induits. Il apparaît en outre clairement que l'invention propose un réacteur amélioré de dépôt assisté par plasma, permettant notamment une assistance du plasma plus douce que les solutions existantes, et donc qui engendre moins de défauts induits.

L'invention n'est pas limitée aux modes de réalisations précédemment décrits et s'étend à tous les modes de réalisation couverts par l'invention. La présente invention ne se limite pas aux exemples précédemment décrits. Bien d'autres variantes de réalisation sont possibles, par exemple par combinaison de caractéristiques précédemment décrites, sans sortir du cadre de l'invention. En outre, les caractéristiques décrites relativement à un aspect de l'invention peuvent être combinées à un autre aspect de l'invention. Notamment, le procédé peut comprendre toute étape résultant de la mise en œuvre d'une caractéristique du réacteur et le réacteur peut présenter toute caractéristique permettant, par exemple un élément configuré pour, la mise en œuvre une étape du procédé.

Dans les exemples illustrés, l'arrivée 12 a été représentée au niveau de la face supérieure 101 du réacteur 1. Une autre disposition, par exemple au niveau de la paroi latérale 100, est possible. Il en va de même pour le module de pompage 13.

## Revendications

1. Procédé (4) de dépôt de couches atomiques assisté par plasma comprenant :
• une fourniture (40) d'un substrat (2) présentant une surface exposée (20) dans un réacteur plasma (1), le réacteur plasma comprenant une chambre de réaction (10) délimitée par des parois (100, 101) et un plateau (110) électriquement conducteur présentant une face supérieure (110a) sur laquelle est disposé le substrat (2),
• une pluralité de cycles (41) de dépôt de couches atomiques sur la surface exposée (20) du substrat (2), chaque cycle comprenant :
∘ une injection dans la chambre de réaction d'un précurseur à base d'une première espèce (410),
∘ un traitement plasma (412) de la surface exposée (20) du substrat (2),
le procédé étant **caractérisé en ce qu'**une paroi latérale (100) de la chambre de réaction est au moins en partie non parallèle à la face supérieure (110a) du plateau (110) et étant électriquement conductrice, et le traitement plasma de la surface exposée (20) du substrat (2) est un traitement plasma par couplage capacitif entre le plateau (110) et ladite paroi latérale (100), par application d'une puissance radiofréquence au plateau (110).

2. Procédé (4) selon la revendication précédente, dans lequel la pluralité de cycles (41) de dépôt comprend en outre une injection dans la chambre de réaction d'un précurseur à base d'une deuxième espèce (413).

3. Procédé (4) selon l'une quelconque des revendications précédentes, dans lequel le traitement plasma (412) est effectué simultanément à au moins une injection dans la chambre de réaction d'un précurseur (410, 413) ou suite à au moins une injection dans la chambre de réaction d'un précurseur (410, 413).

4. Procédé (4) selon l'une quelconque des revendications précédentes, dans lequel la puissance radiofréquence est inférieure ou égale à 80 W, la pression dans la chambre de réaction (10) est inférieure ou égale à 80 mTorr, et la durée du traitement plasma (412) au cours d'un cycle (41) de dépôt est inférieure ou égale à 1 minute.

5. Procédé (4) selon l'une quelconque des revendications précédentes, dans lequel la puissance radiofréquence est supérieure ou égale à 50 W, la pression dans la chambre de réaction (10) est inférieure ou égale à 20 mTorr, et la durée du traitement plasma (412) au cours d'un cycle (41) de dépôt est supérieure ou égale à 1 minute.

6. Procédé (4) selon l'une quelconque des revendications précédentes, dans lequel lorsque le plasma est généré, le traitement plasma (412) comprend l'injection dans la chambre de réaction d'un gaz rare, de préférence de l'argon, éventuellement en mélange avec H₂.

7. Procédé (4) selon l'une quelconque des revendications précédentes, dans lequel le traitement plasma (412) étant effectué simultanément à et/ou après l'injection du précurseur à base de la première espèce (410), la première espèce est à base d'un métal.

8. Procédé (4) selon la revendication précédente, dans lequel lorsque le plasma est généré, le traitement plasma (412) est exempt d'injection de dihydrogène.

9. Procédé (4) selon l'une quelconque des deux revendications précédentes, dans lequel le métal présente une électronégativité comprise entre 1,1 et 2,4.

10. Procédé (4) selon l'une quelconque des trois revendications précédentes, dans lequel la première espèce comprend le métal et des ligands alkyls, amines, oxygénés ou halogénés.

11. Procédé (4) selon l'une quelconque des revendications 7, 9 et 10, dans lequel le traitement plasma (412) étant effectué simultanément à l'injection du précurseur à base de la première espèce (410), le traitement plasma (412) et l'injection dudit précurseur (410) sont chacun fait par impulsions simultanées ou séquentielles entre le traitement plasma (412) et l'injection dudit précurseur (410).

12. Procédé (4) selon l'une quelconque des revendications 2 à 6, dans lequel, le traitement plasma (412) étant effectué après l'injection du précurseur à base de la première espèce et/ou après l'injection du précurseur à base de la deuxième espèce, la première espèce est à base d'un métal et la deuxième espèce comprend l'un au moins parmi les éléments oxygène, azote et soufre.

13. Procédé (4) selon la revendication précédente, le traitement plasma (412) étant effectué simultanément à l'injection du précurseur à base de la deuxième espèce (413), la deuxième espèce est choisie parmi le groupe constitué de O₂, N₂ (éventuellement en mélange avec H₂), NH₃, H₂S.

14. Procédé (4) selon la revendication 12, le traitement plasma (412) étant effectué après l'injection du précurseur à base de la deuxième espèce (413), la deuxième espèce est choisie parmi le groupe constitué de H₂O, O₂, NH₃.

15. Procédé (4) selon l'une quelconque des revendications précédentes, dans lequel le plateau (110) étant configuré pour être ajusté en hauteur dans la chambre de réaction (10), le procédé comprend un ajustement de la hauteur du plateau préalablement au traitement plasma (412), de préférence préalablement au cycle (41) de dépôt.

## Patentansprüche

1. Verfahren (4) zur plasmaunterstützten Abscheidung von Atomschichten, umfassend:
• Bereitstellen (40) eines Substrats (2), das eine freiliegenden Oberfläche (20) in einem Plasmareaktor (1) besitzt, wobei der Plasmareaktor eine Reaktionskammer (10), die durch Wände (100, 101) begrenzt ist, und eine elektrisch leitfähige Platte (110) mit einer Oberseite (110a) umfasst, auf der das Substrat (2) angeordnet ist,
• eine Vielzahl von Zyklen (41) zum Abscheiden von Atomschichten auf der freiliegenden Oberfläche (20) des Substrats (2), wobei jeder Zyklus umfasst:
∘ ein Einspeisen eines Vorläufers auf Basis einer ersten Spezies (410) in die Reaktionskammer,
∘ eine Plasmabehandlung (412) der freiliegenden Oberfläche (20) des Substrats (2),
wobei das Verfahren **dadurch gekennzeichnet ist, dass** eine Seitenwand (100) der Reaktionskammer mindestens teilweise nicht parallel zu der Oberseite (110a) der Platte (110) liegt und elektrisch leitfähig ist, und die Plasmabehandlung der freiliegenden Oberfläche (20) des Substrats (2) eine Plasmabehandlung durch kapazitive Kopplung zwischen der Platte (110) und der Seitenwand (100) durch Anlegen einer Radiofrequenzleistung an die Platte (110) ist.

2. Verfahren (4) nach dem vorhergehenden Anspruch, wobei die Vielzahl von Abscheidezyklen (41) ferner das Einspeisen eines Vorläufers auf Basis einer zweiten Spezies (413) in die Reaktionskammer umfasst.

3. Verfahren (4) nach einem der vorhergehenden Ansprüche, wobei die Plasmabehandlung (412) gleichzeitig mit mindestens einem Einspeisen eines Vorläufers (410, 413) in die Reaktionskammer oder nach mindestens einem Einspeisen eines Vorläufers (410, 413) in die Reaktionskammer durchgeführt wird.

4. Verfahren (4) nach einem der vorhergehenden Ansprüche, wobei die Radiofrequenzleistung kleiner oder gleich 80 W ist, der Druck in der Reaktionskammer (10) kleiner oder gleich 80 mTorr ist und die Dauer der Plasmabehandlung (412) während eines Abscheidezyklus (41) kleiner oder gleich 1 Minute ist.

5. Verfahren (4) nach einem der vorhergehenden Ansprüche, wobei die Radiofrequenzleistung größer oder gleich 50 W ist, der Druck in der Reaktionskammer (10) kleiner oder gleich 20 mTorr ist und die Dauer der Plasmabehandlung (412) während eines Abscheidezyklus (41) größer oder gleich 1 Minute ist.

6. Verfahren (4) nach einem der vorhergehenden Ansprüche, wobei, wenn das Plasma erzeugt wird, die Plasmabehandlung (412) das Einspeisen eines Edelgases, vorzugsweise Argon, gegebenenfalls in Mischung mit H₂, in die Reaktionskammer umfasst.

7. Verfahren (4) nach einem der vorhergehenden Ansprüche, wobei die Plasmabehandlung (412) gleichzeitig mit und/oder nach dem Einspeisen des Vorläufers auf Basis der ersten Spezies (410) durchgeführt wird, wobei die erste Spezies auf einem Metall basiert.

8. Verfahren (4) nach dem vorhergehenden Anspruch, wobei, wenn das Plasma erzeugt wird, die Plasmabehandlung (412) ohne Einspeisen von Diwasserstoff ist.

9. Verfahren (4) nach einem der beiden vorhergehenden Ansprüche, wobei das Metall eine Elektronegativität zwischen 1,1 und 2,4 aufweist.

10. Verfahren (4) nach einem der drei vorhergehenden Ansprüche, wobei die erste Spezies das Metall und Alkyl-, Amin-, sauerstoffhaltige oder halogenierte Liganden umfasst.

11. Verfahren (4) nach einem der Ansprüche 7, 9 und 10, wobei die Plasmabehandlung (412) gleichzeitig mit dem Einspeisen des Vorläufers auf Basis der ersten Spezies (410) durchgeführt wird, wobei die Plasmabehandlung (412) und das Einspeisen des Vorläufers (410) jeweils durch gleichzeitige oder sequenzielle Impulse zwischen der Plasmabehandlung (412) und dem Einspeisen des Vorläufers (410) erfolgen.

12. Verfahren (4) nach einem der Ansprüche 2 bis 6, wobei die Plasmabehandlung (412) nach dem Einspeisen des Vorläufers auf Basis der ersten Spezies und/oder nach dem Einspeisen des Vorläufers auf Basis der zweiten Spezies durchgeführt wird, wobei die erste Spezies auf einem Metall basiert und die zweite Spezies mindestens eines der Elemente Sauerstoff, Stickstoff und Schwefel umfasst.

13. Verfahren (4) nach dem vorhergehenden Anspruch, wobei die Plasmabehandlung (412) gleichzeitig mit dem Einspeisen des Vorläufers auf Basis der zweiten Spezies (413) durchgeführt wird, wobei die zweite Spezies aus der Gruppe ausgewählt wird, die aus O₂, N₂ (eventuell in Mischung mit H₂), NH₃ und H₂S besteht.

14. Verfahren (4) nach Anspruch 12, wobei die Plasmabehandlung (412) nach dem Einspeisen des Vorläufers auf Basis der zweiten Spezies (413) durchgeführt wird, wobei die zweite Spezies aus der Gruppe ausgewählt wird, die aus H₂O, O₂ und NH₃ besteht.

15. Verfahren (4) nach einem der vorhergehenden Ansprüche, wobei die Platte (110) so konfiguriert ist, dass sie in der Reaktionskammer (10) in der Höhe angepasst werden kann, wobei das Verfahren eine Anpassung der Höhe der Platte vor der Plasmabehandlung (412), vorzugsweise vor dem Abscheidezyklus (41) umfasst.

## Claims

1. Plasma-enhanced atomic layer deposition method (4) comprising:
• a supply (40) of a substrate (2) having an exposed surface (20) in a plasma reactor (1), the plasma reactor comprising a reaction chamber (10) delimited by walls (100, 101) and an electrically conductive plate (110) having an upper face (110a) whereon the substrate (2) is disposed,
• a plurality of atomic layer deposition cycles (41) on the exposed surface (20) of the substrate (2), each cycle comprising:
∘ an injection into the reaction chamber of a precursor based on a first species (410),
∘ a plasma treatment (412) of the exposed surface (20) of the substrate (2),
the method being **characterised in that** a side wall (100) of the reaction chamber is at least in part non-parallel to the upper face (110a) of the plate (110) and being electrically conductive, and the plasma treatment of the exposed surface (20) of the substrate (2) is a plasma treatment by capacitive coupling between the plate (110) and said side wall (100), by applying a radiofrequency power to the plate (110).

2. Method (4) according to the preceding claim, wherein the plurality of deposition cycles (41) further comprises an injection into the reaction chamber of a precursor based on a second species (413).

3. Method (4) according to any one of the preceding claims, wherein the plasma treatment (412) is performed simultaneously with at least one injection into the reaction chamber of a precursor (410, 413) or following at least one injection into the reaction chamber of a precursor (410, 413).

4. Method (4) according to any one of the preceding claims, wherein the radiofrequency power is less than or equal to 80 W, the pressure at the reaction chamber (10) is less than or equal to 80 mTorr, and the duration of the plasma treatment (412) during a deposition cycle (41) is less than or equal to 1 minute.

5. Method (4) according to any one of the preceding claims, wherein the radiofrequency polarisation power is greater than or equal to 50 W, the pressure in the reaction chamber (10) is less than or equal to 20 mTorr, and the duration of the plasma treatment (412) during a deposition cycle (41) is greater than or equal to 1 minute.

6. Method (4) according to any one of the preceding claims, wherein when the plasma is generated, the plasma treatment (412) comprises the injection into the reaction chamber of a rare gas, preferably argon, optionally in a mixture with H₂.

7. Method (4) according to any one of the preceding claims, wherein the plasma treatment (412) being performed simultaneously with and/or after the injection of the precursor based on the first species (410), the first species is based on a metal.

8. Method (4) according to the preceding claim, wherein when the plasma is generated, the plasma treatment (412) is free from dihydrogen injection.

9. Method (4) according to any one of the two preceding claims, wherein the metal has an electronegativity between 1.1 and 2.4.

10. Method (4) according to any one of the three preceding claims, wherein the first species comprises the metal and alkyl, amine, oxygenated or halogenated ligands.

11. Method (4) according to any one of claims 7, 9 and 10, wherein the plasma treatment (412) being performed simultaneously with the injection of the precursor based on the first species (410), the plasma treatment (412) and the injection of said precursor (410) are each performed by simultaneous or sequential pulses between the plasma treatment (412) and the injection of said precursor (410).

12. Method (4) according to any one of claims 2 to 6, wherein, the plasma treatment (412) being performed after the injection of the precursor based on the first species and/or after the injection of the precursor based on the second species, the first species is based on a metal and the second species comprises at least one among the elements oxygen, nitrogen and sulphur.

13. Method (4) according to the preceding claim, the plasma treatment (412) being performed simultaneously with the injection of the precursor based on the second species (413), the second species is chosen from the group consisting of O₂, N₂ (optionally in a mixture with H₂), NH₃, H₂S.

14. Method (4) according to claim 12, the plasma treatment (412) being performed after the injection of the precursor based on the second species (413), the second species is chosen from the group consisting of H₂O, O₂, NH₃.

15. Method (4) according to any one of the preceding claims, wherein the plate (110) being configured to be adjusted in height in the reaction chamber (10), the method comprises an adjustment of the height of the plate prior to the plasma treatment (412), preferably prior to the deposition cycle (41).
